(19) Europäisches Patentamt
European Patent Office
Office européen des brevets

(11) EP 2 609 640 B1

(12) **EUROPEAN PATENT SPECIFICATION**

(45) Date of publication and mention of the grant of the patent:
**25.11.2015 Bulletin 2015/48**

(21) Application number: **11755170.5**

(22) Date of filing: **24.08.2011**

(51) Int Cl.:
***H01L 51/50*** *(2006.01)* ***H01L 51/00*** *(2006.01)*
***C09K 11/06*** *(2006.01)*

(86) International application number:
**PCT/US2011/048890**

(87) International publication number:
**WO 2012/027427 (01.03.2012 Gazette 2012/09)**

# (54) PHOTOACTIVE COMPOSITION AND ELECTRONIC DEVICE MADE WITH THE COMPOSITION

FOTOAKTIVE ZUSAMMENSETZUNG UND MIT DER ZUSAMMENSETZUNG HERGESTELLTE ELEKTRONISCHE VORRICHTUNG

COMPOSITION PHOTOACTIVE ET DISPOSITIF ÉLECTRONIQUE FABRIQUÉ AVEC CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2010 US 376406 P**

(43) Date of publication of application:
**03.07.2013 Bulletin 2013/27**

(73) Proprietor: **E. I. du Pont de Nemours and Company**
**Wilmington, DE 19898 (US)**

(72) Inventors:
- **GAO, Weiying**
**Landenberg**
**Pennsylvania 19350 (US)**
- **HERRON, Norman**
**Newark**
**Delaware 19711 (US)**

(74) Representative: **Towler, Philip Dean et al**
**Dehns**
**St Bride's House**
**10 Salisbury Square**
**London EC4Y 8JD (GB)**

(56) References cited:
**WO-A1-2010/069442** **WO-A1-2011/019360**
**WO-A2-2010/068865** **JP-A- 2009 170 814**
**JP-A- 2009 170 818** **US-A1- 2004 178 720**
**US-A1- 2005 084 710** **US-A1- 2007 247 061**
**US-A1- 2010 187 981**

- **YUTAKA OHMORI ET AL: "Organic Light-Emitting Diodes Fabricated by a Solution Process and Their Stress Tolerance", JOURNAL OF DISPLAY TECHNOLOGY, IEEE SERVICE CENTER, NEW YORK, NY, US, vol. 3, no. 2, 1 June 2007 (2007-06-01), pages 238-244, XP011182144, ISSN: 1551-319X, DOI: 10.1109/JDT.2007.895356**
- **GUFENG HE: "Ultra-high-efficiency electrophosphorescent p-i-n OLEDs with double emission layers", PROCEEDINGS OF SPIE, vol. 5519, 2 August 2004 (2004-08-02), pages 42-47, XP55011248, ISSN: 0277-786X, DOI: 10.1117/12.563310**
- **KLEMENS BRUNNER ET AL: "Carbazole Compounds as Host Materials for Triplet Emitters in Organic Light-Emitting Diodes: Tuning the HOMO Level without Influencing the Triplet Energy in Small Molecules", JOURNAL OF THE AMERICAN CHEMICAL SOCIETY, vol. 126, no. 19, 23 April 2004 (2004-04-23), pages 6035-6042, XP55011159, ISSN: 0002-7863, DOI: 10.1021/ja049883a**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 609 640 B1

- AKIHIKO TERAMURA ET AL: "Markedly Different Rise and Fall Times in Transient Electroluminescence of 4,4'-N,N'-Dicarbazolylbiphenyl:fac-Tris(2- phen ylpyridinate) Iridium(III)-Based Organic Light Emitting Diodes", JAPANESE JOURNAL OF APPLIED PHYSICS, JAPAN SOCIETY OF APPLIED PHYSICS, JP, vol. 48, no. 11, 1 November 2009 (2009-11-01), pages 111505-1, XP001551748, ISSN: 0021-4922, DOI: 10.1143/JJAP.48.111505 [retrieved on 2009-11-20]

## Description

BACKGROUND INFORMATION

Field of the Disclosure

This disclosure relates in general to photoactive compositions that are useful in organic electronic devices.

Description of the Related Art

In organic photoactive electronic devices, such as organic light emitting diodes ("OLED"), that make up OLED displays, the organic active layer is sandwiched between two electrical contact layers. In an OLED, the organic photoactive layer emits light through the light-transmitting electrical contact layer upon application of a voltage across the electrical contact layers.

It is well known to use organic electroluminescent compounds as the active component in light-emitting diodes. Simple organic molecules, conjugated polymers, and organometallic complexes have been used.

Devices that use photoactive materials frequently include one or more charge transport layers, which are positioned between a photoactive and a contact layer. A device can contain two or more contact layers. A hole transport layer can be positioned between the photoactive layer and the hole-injecting contact layer. The hole-injecting contact layer may also be called the anode. An electron transport layer can be positioned between the photoactive layer and the electron-injecting contact layer. The electron-injecting contact layer may also be called the cathode. Charge transport materials can also be used as hosts in combination with the photoactive materials.

WO2010/069442 discloses organic electroluminescent devices which contain ketone or phosphine oxide derivatives and at least two phosphorescent compounds.

Ohmori et al., Journal of Display Technology, vol. 3, no. 2, June 2007, discloses organic LEDs fabricated by a solution process and their stress tolerance.

WO2010/068865 discloses a photoactive composition including a first and a second host material and an electroluminescent dopant material.

There is a continuing need for new materials for electronic devices.

SUMMARY

There is provided a photoactive composition comprising:

(a) 50-99 wt% based on the total weight of the photoactive composition, of at least one host material having a HOMO energy level;
(b) 1-10 wt% based on the total weight of the photoactive composition, of an emissive dopant;
(c) 0.1 to 10 wt% based on the total weight of the photoactive composition, of a non-emissive dopant, wherein the non-emissive dopant is an organometallic iridium complex having a HOMO energy level shallower than the HOMO energy level of the first host and a wider band gap than the emissive dopant;
and
(d) 1-49 wt% based on the total weight of the photoactive composition, of a second host material having a HOMO energy level that is deeper than the HOMO energy level of the non-emissive dopant,
wherein the first host material has Formula I

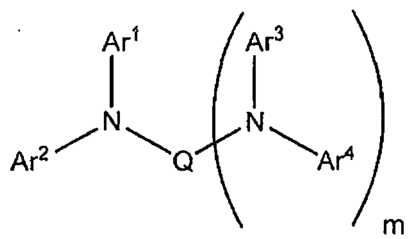

where:

$Ar^1$ to $Ar^4$ are the same or different and are aryl;
Q is chrysene, phenanthrene, triphenylene, phenanthroline, naphthalene, anthracene, quinoline, or isoquinoline;

and
m is an integer from 0-6.

There is also provided an organic electronic device comprising an anode, a hole transport layer, a photoactive layer, an electron transport layer, and a cathode, wherein the photoactive layer comprises the photoactive composition described above.
There is also provided a process for making an organic light-emitting device comprising:

providing a substrate having a patterned anode thereon;
forming a hole transport layer by depositing a liquid composition comprising a hole transport material in a first liquid medium;
forming a photoactive layer by depositing a liquid composition comprising the photoactive composition described above;
forming an electron transport layer; and
forming a cathode overall.

The foregoing general description and the following detailed description are exemplary and explanatory only and are not restrictive of the invention, as defined in the appended claims.

BRIEF DESCRIPTION OF THE DRAWINGS

Embodiments are illustrated in the accompanying figures to improve understanding of concepts as presented herein.

FIG. 1A includes a diagram of HOMO and LUMO energy levels.
FIG. 1B includes a diagram of HOMO and LUMO energy levels of two different materials.
FIG. 2 includes an illustration of an exemplary organic device.
FIG. 3 includes an illustration of another exemplary organic device.

Skilled artisans appreciate that objects in the figures are illustrated for simplicity and clarity and have not necessarily been drawn to scale. For example, the dimensions of some of the objects in the figures may be exaggerated relative to other objects to help to improve understanding of embodiments.

DETAILED DESCRIPTION

The detailed description first addresses Definitions and Clarification of Terms followed by the Photoactive Composition, the Electronic Device, and finally Examples.

1. Definitions and Clarification of Terms

Before addressing details of embodiments described below, some terms are defined or clarified.
The term "alkyl" is intended to mean a group derived from an aliphatic hydrocarbon. In some embodiments, the alkyl group has from 1-20 carbon atoms.
The term "aryl" is intended to mean a group derived from an aromatic hydrocarbon. The term "aromatic compound" is intended to mean an organic compound comprising at least one unsaturated cyclic group having delocalized pi electrons. The term is intended to encompass both aromatic compounds having only carbon and hydrogen atoms, and heteroaromatic compounds wherein one or more of the carbon atoms within the cyclic group has been replaced by another atom, such as nitrogen, oxygen, sulfur, or the like. In some embodiments, the aryl group has from 4-30 carbon atoms.
The term "charge transport," when referring to a layer, material, member, or structure is intended to mean such layer, material, member, or structure facilitates migration of such charge through the thickness of such layer, material, member, or structure with relative efficiency and small loss of charge. Hole transport materials facilitate positive charge; electron transport materials facilitate negative charge. Although light-emitting and light-receiving materials may also have some charge transport properties, the term "charge transport layer, material, member, or structure" is not intended to include a layer, material, member, or structure whose primary function is light emission or light reception.
The term "emissive dopant" is intended to mean a material, within a layer including a host material, that changes the electronic characteristic(s) or the targeted wavelength(s) of radiation emission, reception, or filtering of the layer compared to the electronic characteristic(s) or the wavelength(s) of radiation emission, reception, or filtering of the layer

in the absence of such material.

The term "fused aryl" refers to an aryl group having two or more fused aromatic rings.

The term "HOMO" refers to the highest occupied molecular orbital. The HOMO energy level is measured relative to vacuum level, as illustrated in FIG. 1A. By convention, the HOMO is given as a negative value, i.e. the vacuum level is set as zero and the bound electron energy levels are deeper than this. By "deeper" it is meant that the level is further removed from vacuum level. By "shallower" it is meant that the level is closer to the vacuum level. This is illustrated in FIG. 1B, where HOMO B is shallower than HOMO A. Conversely, HOMO A is deeper than HOMO B.

The term "host material" is intended to mean a material, usually in the form of a layer, to which a dopant may or may not be added. The host material may or may not have electronic characteristic(s) or the ability to emit, receive, or filter radiation.

The term "layer" is used interchangeably with the term "film" and refers to a coating covering a desired area. The term is not limited by size. The area can be as large as an entire device or as small as a specific functional area such as the actual visual display, or as small as a single sub-pixel. Layers and films can be formed by any conventional deposition technique, including vapor deposition, liquid deposition (continuous and discontinuous techniques), and thermal transfer. Continuous deposition techniques, include but are not limited to, spin coating, gravure coating, curtain coating, dip coating, slot-die coating, spray coating, and continuous nozzle coating. Discontinuous deposition techniques include, but are not limited to, ink jet printing, gravure printing, and screen printing.

The term "LUMO" refers to the lowest unoccupied molecular orbital. The LUMO energy level is measured relative to vacuum level in eV, as illustrated in FIG. 1A. By convention, the LUMO is a negative value, i.e. the vacuum level is set as zero and the bound electron energy levels are deeper than this. A "deeper" level is farther removed from vacuum level. This is illustrated in FIG. 1B, where LUMO B is deeper than LUMO A.

The term "organic electronic device," or sometimes just "electronic device," is intended to mean a device including one or more organic semiconductor layers or materials.

The term "organometallic" as it refers to metal complexes is intended to mean that the complex has a metal-carbon bond.

The term "photoactive" is intended to mean a material or layer that emits light when activated by an applied voltage (such as in a light emitting diode or chemical cell) or responds to radiant energy and generates a signal with or without an applied bias voltage (such as in a photodetector).

The term "silyl" refers to the group $-SiR_3$, where R is the same or different at each occurrence and is selected from the group consisting of alkyl groups, and aryl groups.

The term "Tg" refers to the glass transition temperature of a material.

The term "triplet energy" refers to the lowest excited triplet state of a material, in eV. Triplet energies are reported as positive numbers and represent the energy of the triplet state above the ground state, usually a singlet state.

Unless otherwise indicated, all groups can be unsubstituted or substituted. Unless otherwise indicated, all groups can be linear, branched or cyclic, where possible. In some embodiments, the substituents are selected from the group consisting of alkyl, alkoxy, aryl, and silyl.

In this specification, unless explicitly stated otherwise or indicated to the contrary by the context of usage, where an embodiment of the subject matter hereof is stated or described as comprising, including, containing, having, being composed of or being constituted by or of certain features or elements, one or more features or elements in addition to those explicitly stated or described may be present in the embodiment. An alternative embodiment of the disclosed subject matter hereof, is described as consisting essentially of certain features or elements, in which embodiment features or elements that would materially alter the principle of operation or the distinguishing characteristics of the embodiment are not present therein. A further alternative embodiment of the described subject matter hereof is described as consisting of certain features or elements, in which embodiment, or in insubstantial variations thereof, only the features or elements specifically stated or described are present. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of "a" or "an" are employed to describe elements and components described herein. This is done merely for convenience and to give a general sense of the scope of the invention. This description should be read to include one or at least one and the singular also includes the plural unless it is obvious that it is meant otherwise.

Group numbers corresponding to columns within the Periodic Table of the elements use the "New Notation" convention as seen in the CRC Handbook of Chemistry and Physics, 81st Edition (2000-2001).

Unless otherwise defined, all technical and scientific terms used herein have the same meaning as commonly understood by one of ordinary skill in the art to which this invention belongs. Although methods and materials similar or equivalent to those described herein can be used in the practice or testing of embodiments of the present invention, suitable methods and materials are described below. In addition, the materials, methods, and examples are illustrative only and not intended to be limiting.

To the extent not described herein, many details regarding specific materials, processing acts, and circuits are

conventional and may be found in textbooks and other sources within the organic light-emitting diode display, photodetector, photovoltaic, and semiconductive member arts.

2. Photoactive Composition

In OLEDs, electrons and holes are injected into the photoactive layer where they recombine to generate light. Balancing the electrons and holes is key for high efficiency. In general, OLEDs tend to have more holes than electrons flowing through the photoactive layer. Organic material, in general, transports holes faster than electrons. As a result, the efficiency is reduced as the holes get wasted without sufficient electrons with which to recombine and generate light. Device lifetime can often also be degraded as excess holes flow into the electron transport layer. Materials having strong electron mobility, such as phenanthroline derivatives, have been used in the electron transport layer to increase electron current. Electrically doped electron transport layers have also been used to increase electron conductivity. However, the doping method frequently requires co-evaporation of materials which add complexity to the manufacturing process. In addition, exciton quenching may be caused by the charge-transfer species in the donor-acceptor pair. Neither of the methods is adjustable in terms of electron current. Over-supplying electrons can also lead to lower efficiency and degraded device lifetime.

The photoactive compositions described herein include a non-emissive dopant which can function as a hole-trapping material to improved device lifetime and efficiency.

The photoactive compositions described herein comprise:

(a) 50-99 wt% based on the total weight of the photoactive composition, of at least one host material having a HOMO energy level;
(b) 1-10 wt% based on the total weight of the photoactive composition, of an emissive dopant; and
(c) 0.1 to 10 wt% based on the total weight of the photoactive composition, of a non-emissive dopant, wherein the non-emissive dopant is an organometallic iridium complex having a HOMO energy level shallower than the HOMO energy level of the first host and a wider band gap than the emissive dopant; and
(d) 1-49 wt% based on the total weight of the photoactive composition, of a second host material having a HOMO energy level that is deeper than the HOMO energy level of the non-emissive dopant,
wherein the first host material has Formula I

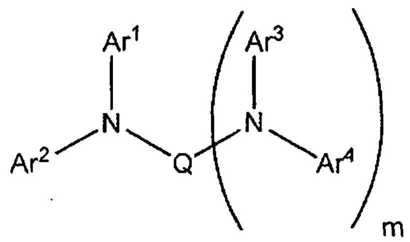

where:

$Ar^1$ to $Ar^4$ are the same or different and are aryl;
Q is chrysene, phenanthrene, triphenylene, phenanthroline, naphthalene, anthracene, quinoline, or isoquinoline; and
m is an integer from 0-6.

In some embodiments, the first and optional second host materials each have a solubility in toluene of at least 0.6 wt%. In some embodiments, the solubility is at least 1 wt%.

In some embodiments, the weight ratio of first host material to second host material is in the range of 19:1 to 2:1; in some embodiments, 9:1 to 2.3:1.

In some embodiments, the weight ratio of total host material (first host + second host) to the emissive dopant is in the range of 5:1 to 25:1; in some embodiments, from 10:1 to 20:1.

In some embodiments, the photoactive composition consists essentially of the host material, the emissive dopant, and the non-emissive dopant, as defined and in the percentages given above.

In some embodiments, the photoactive composition consists essentially of the host material, the emissive dopant, the non-emissive dopant, and a second host material, as defined and in the percentages given above.

In some embodiments, at least one of the components of the photoactive composition is deuterated. The term "deuterated" is intended to mean that at least one H has been replaced by D. The deuterium is present in at least 100

times the natural abundance level. A "deuterated derivative" of compound X has the same structure as compound X, but with at least one D replacing an H. The terms "% deuterated" and "% deuteration" refer to the ratio of deuterons to the sum of protons and deuterons, expressed as a percentage. Thus, for the compound $C_6H_4D_2$ the % deuteration is:

$$2/(4+2) \times 100 = 33\% \text{ deuteration.}$$

In some embodiments, the host material is deuterated. In some embodiments, the deuterated host is at least 10% deuterated; in some embodiments, at least 20% deuterated; in some embodiments, at least 30% deuterated; in some embodiments, at least 40% deuterated; in some embodiments, at least 50% deuterated; in some embodiments, at least 60% deuterated; in some embodiments, at least 70% deuterated; in some embodiments, at least 80% deuterated; in some embodiments, at least 90% deuterated; in some embodiments, 100% deuterated.

In some embodiments, the emissive dopant is deuterated. In some embodiments, the deuterated emissive dopant is at least 10% deuterated; in some embodiments, at least 20% deuterated; in some embodiments, at least 30% deuterated; in some embodiments, at least 40% deuterated; in some embodiments, at least 50% deuterated; in some embodiments, at least 60% deuterated; in some embodiments, at least 70% deuterated; in some embodiments, at least 80% deuterated; in some embodiments, at least 90% deuterated; in some embodiments, 100% deuterated.

In some embodiments, the non-emissive dopant is deuterated. In some embodiments, the deuterated non-emissive dopant is at least 10% deuterated; in some embodiments, at least 20% deuterated; in some embodiments, at least 30% deuterated; in some embodiments, at least 40% deuterated; in some embodiments, at least 50% deuterated; in some embodiments, at least 60% deuterated; in some embodiments, at least 70% deuterated; in some embodiments, at least 80% deuterated; in some embodiments, at least 90% deuterated; in some embodiments, 100% deuterated.

In some embodiments, two or more of the host, the second host, the emissive dopant and the non-emissive dopant are deuterated. In some embodiments, all the materials in the photoactive composition are deuterated.

The compositions are useful as solution processable photoactive compositions for OLED devices. The resulting devices may have high efficiency and long lifetimes. In some embodiments, the materials are useful in any printed electronics application including photovoltaics and TFTs.

a. Host Material

The host material has a HOMO energy level that is deeper than the HOMO energy level of the non-emissive dopant. Methods for determining the HOMO energy level are well known and understood. In some embodiments, the level is determined by ultraviolet photoelectron spectroscopy ("UPS"). In some embodiments, the HOMO is deeper than -5.0 eV.

In some embodiments, the host material has a Tg greater than 95°C. The high Tg allows for the formation of smooth and robust films. There are two primary ways in which Tg is routinely measured: Differential Scanning Calorimetry ("DSC"), and Thermo-Mechanical Analysis ("TMA"). In some embodiments, the Tg is measured by DSC. In some embodiments the Tg is between 100 and 150°C.

In some embodiments, the host material has a triplet energy level greater than 2.0 eV. This is particularly useful when the dopant is a phosphorescent material in order to prevent quenching of the emission. The triplet energy can either be calculated *a priori,* or be measured using pulse radiolysis or low temperature luminescence spectroscopy.

The first host material has Formula I:

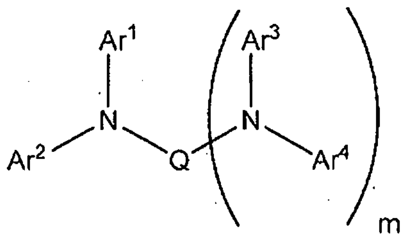

where:

$Ar^1$ to $Ar^4$ are the same or different and are aryl;
Q is chrysene, phenanthrene, triphenylene, phenanthroline, naphthalene, anthracene, quinoline, or isoquinoline; and
m is an integer from 0-6.

In some embodiments of Formula I, adjacent Ar groups are joined together to form rings such as carbazole. In Formula I, "adjacent" means that the Ar groups are bonded to the same N.

In some embodiments, $Ar^1$ to $Ar^4$ are independently selected from the group consisting of phenyl, biphenyl, terphenyl, quaterphenyl, naphthyl, phenanthryl, naphthylphenyl, and phenanthrylphenyl. Analogs higher than quaterphenyl can also be used, having 5-10 phenyl rings.

The groups referred to above are defined as follows, where the dashed lines represent possible points of attachment.

biphenyl:

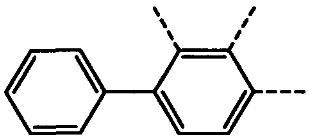

naphthyl:

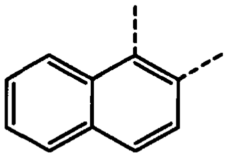

terphenyl:

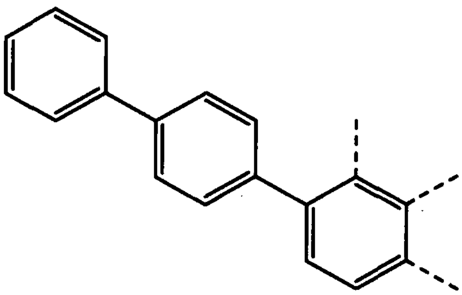

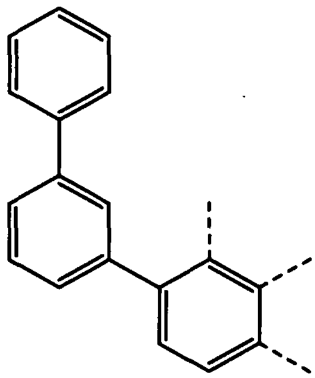

naphthylyphenyl:

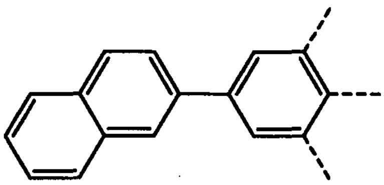

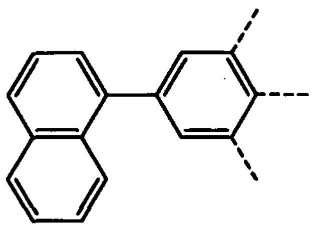

phenanthryl:

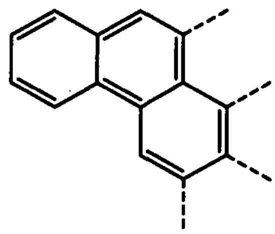

phenanthrylphenyl:

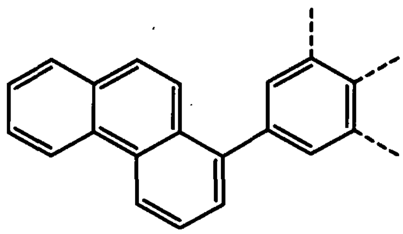

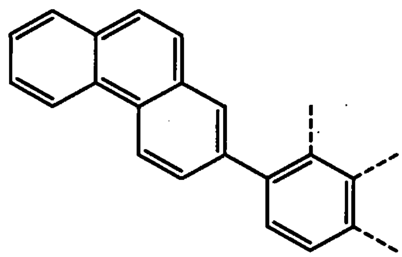

In some embodiments, at least one of $Ar^1$ to $Ar^4$ has at least one substituent. Substituent groups can be present in order to alter the physical or electronic properties of the host material. In some embodiments, the substituents improve the processibility of the host material. In some embodiments, the substituents increase the solubility and/or increase the Tg of the host material. In some embodiments, the substituents are selected from the group consisting of alkyl groups, alkoxy groups, silyl groups, and combinations thereof.

While m can have a value from 0-6, it will be understood that for some Q groups the value of m is restricted by the chemistry of the group. In some embodiments, m is 0 or 1.

In some embodiments, the second host material is selected from the group consisting of phenanthrolines, quinoxalines, phenylpyridines, benzodifurans, and metal quinolinate complexes.

In some embodiments, the second host material is a phenanthroline compound having Formula II:

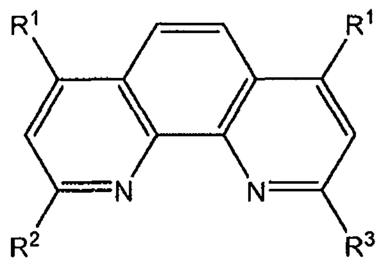

Formula II

where:

| | |
|---|---|
| $R^1$ | is the same or different and is selected from the group consisting of phenyl, naphthyl, naphthylphenyl, triphenylamino, and carbazolylphenyl; |
| $R^2$ and $R^3$ | are the same or different and are selected from the group consisting of phenyl, biphenyl, naphthyl, naphthylphenyl, phenanthryl, triphenylamino, and carbazolylphenyl. In some embodiments of Formula II, R1 through R3 are selected |

from the group consisting of phenyl and substituted phenyl.

In some embodiments of Formula II, both $R^1$ are phenyl and $R^2$ and $R^3$ are selected from the group consisting of 2-naphthyl, naphthylphenyl, phenanthryl, triphenylamino, and m-carbazolylphenyl.

The groups not previously referred to, are defined as follows, where the dashed lines represent possible points of attachment.

triphenylamino:

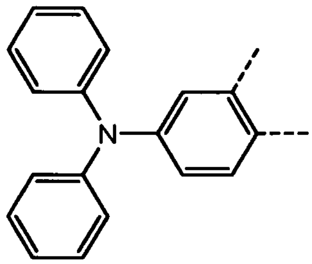

carbazolyl phenyl:

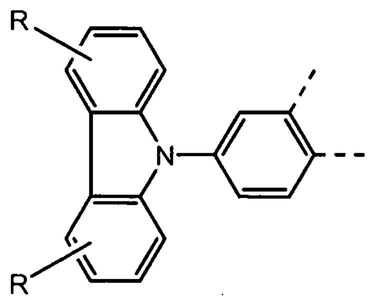

where R = aryl, alkyl

In some embodiments, the phenanthroline compounds are symmetrical, where both $R^1$ are the same and $R^2 = R^3$. In some embodiments, $R^1 = R^2 = R^3$. In some embodiments, the phenanthroline compounds are non-symmetrical, where the two $R^1$ groups are the same but, $R^2 \neq R^3$; the two $R^1$ groups are different and $R^2 = R^3$; or the two $R^1$ groups are different and $R^2 \neq R^3$.

In some embodiments, the $R^1$ groups are the same and are selected from the group consisting of phenyl, triphenylamino, and carbazolylphenyl. In some embodiments, the $R^1$ groups are selected from p-triphenylamino (where the point of attachment is para to the nitrogen) and m-carbazolylphenyl (where the point of attachment is meta to the nitrogen).

In some embodiments, $R^2 = R^3$ and is selected from the group consisting of triphenylamino, naphthylphenyl, triphenylamino, and m-carbazolylphenyl.

Examples of host materials include, but are not limited to, compounds A1 to A21 below.

A1: HOMO = -5.36 eV; Tg = 180°C

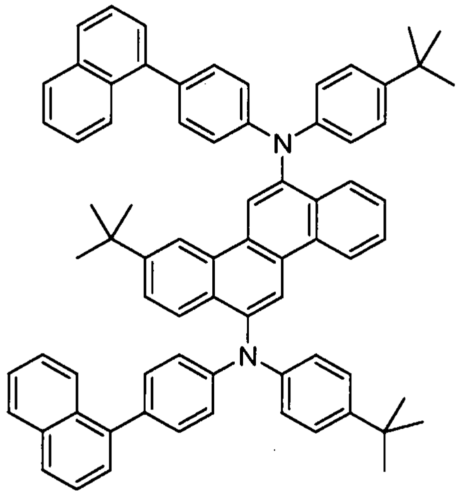

A2: HOMO = -5.36; Tg = 105°C

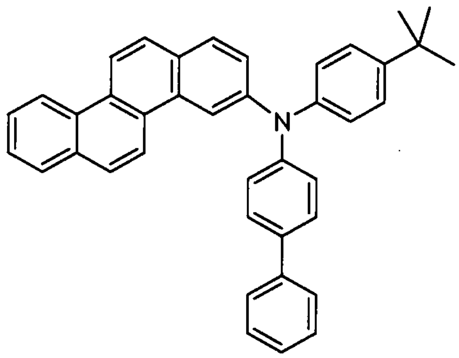

A3: HOMO = -5.66 eV; Tg = 158°C

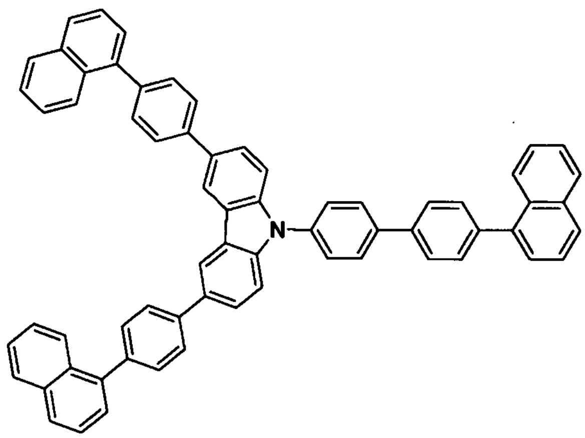

A4:Tg=161°C

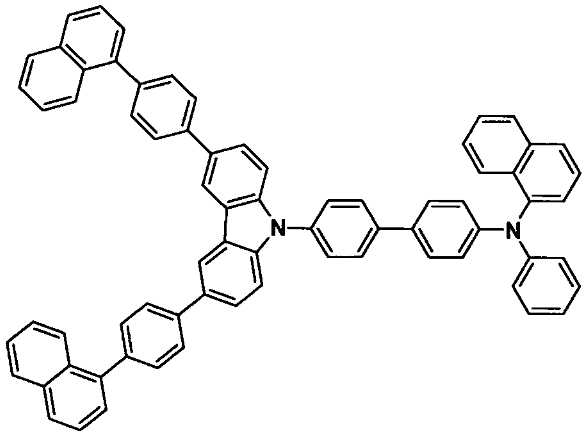

A5: HOMO = -5.39 eV; Tg = 137°C

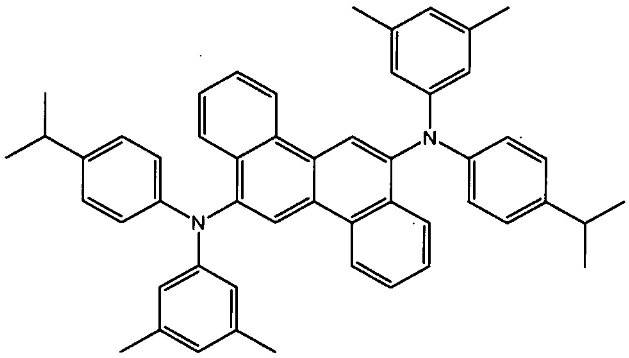

A6: HOMO = -5.57 eV; Tg = 149°C

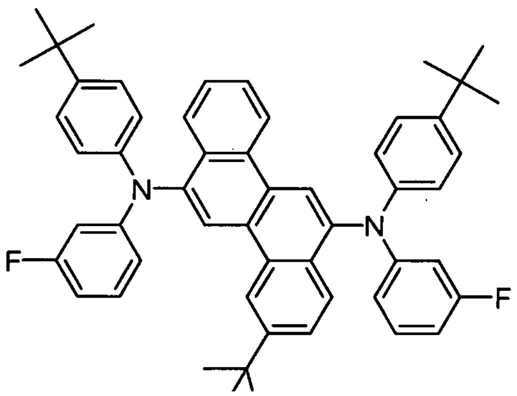

$C_{54}H_{52}F_2N_2$
Exact Mass: 766.41
Mol. Wt.: 767.00
C, 84.56; H, 6.83; F, 4.95; N, 3.65

A7: HOMO = -5.36 eV; Tg = 154°C

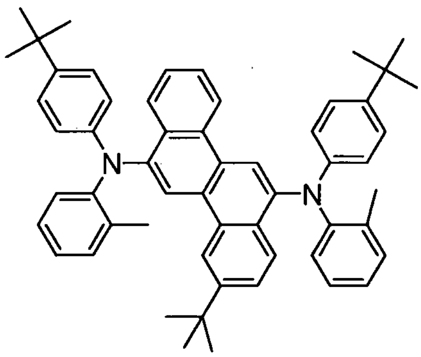

$C_{56}H_{58}N_2$
Exact Mass: 758.46
Mol. Wt.: 759.07
C, 88.61; H, 7.70; N, 3.69

A8: Tg = 160°C

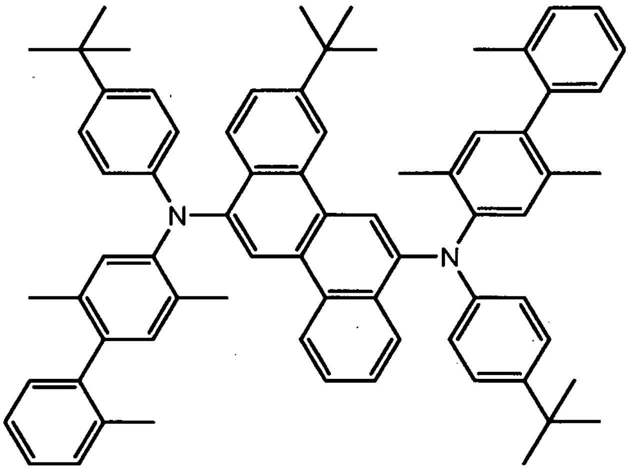

A9: HOMO = -5.51 eV; Tg = 151°C

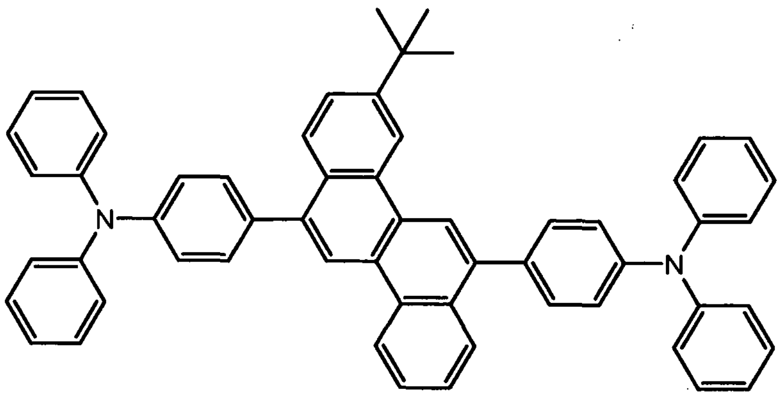

A10: HOMO = -5.5eV; Tg = 156°C

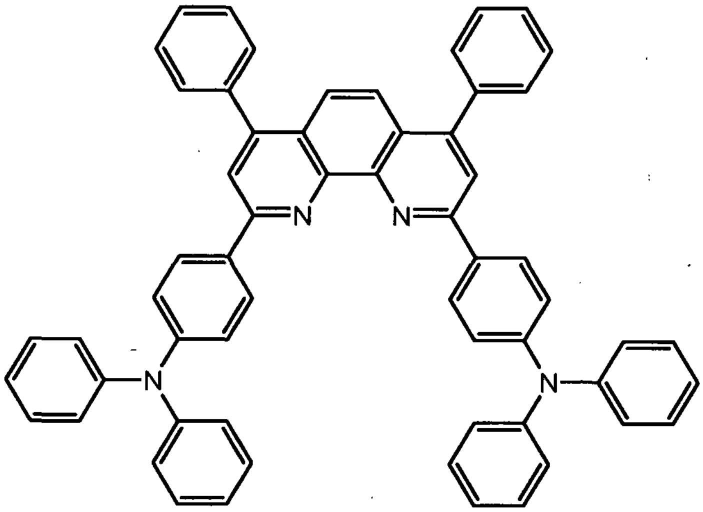

A11: HOMO = -5.46 eV; Tg = 110°C

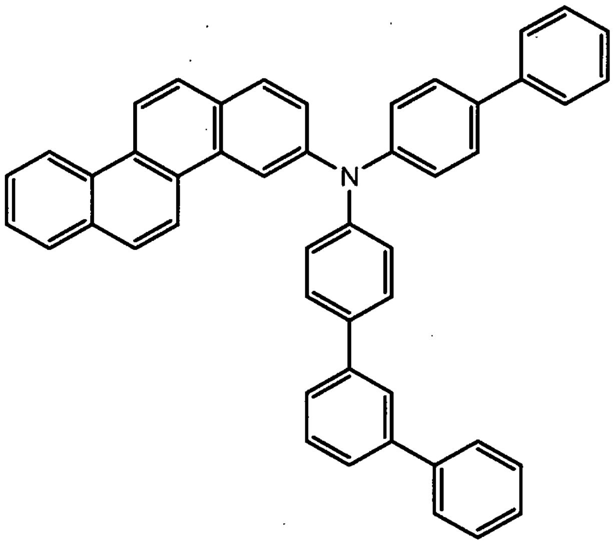

A12: Tg = 116°C

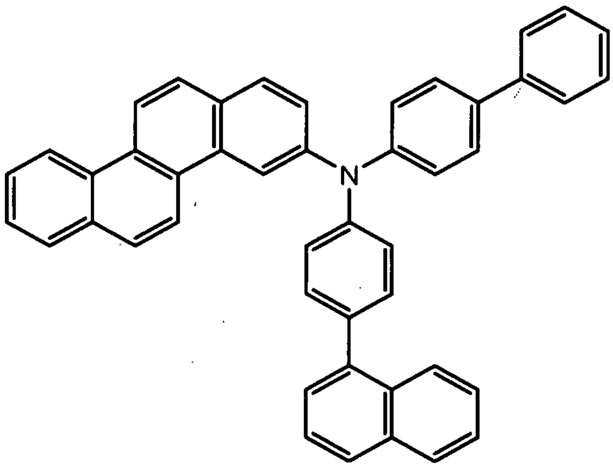

A13: Tg = 120°C

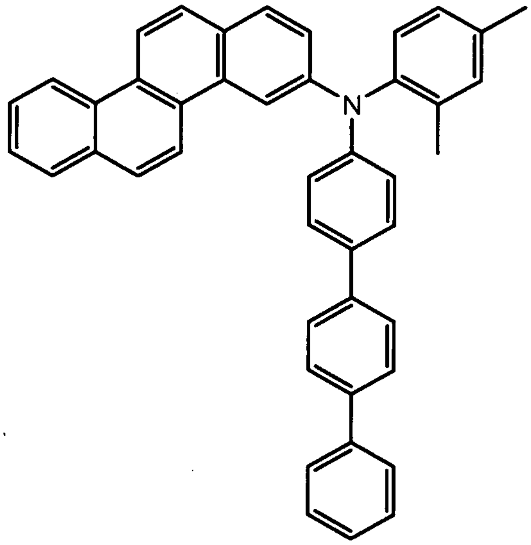

A14: HOMO = -5.56 eV; Tg = 110°C

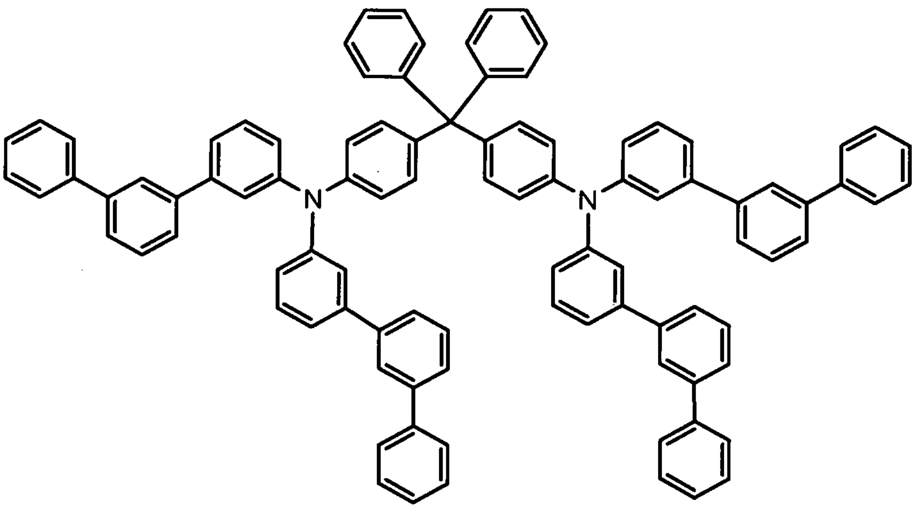

A15:

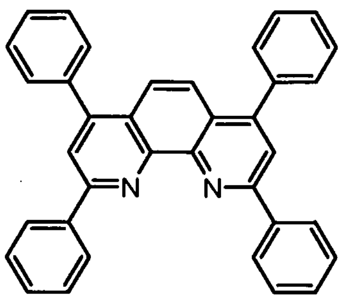

A16:

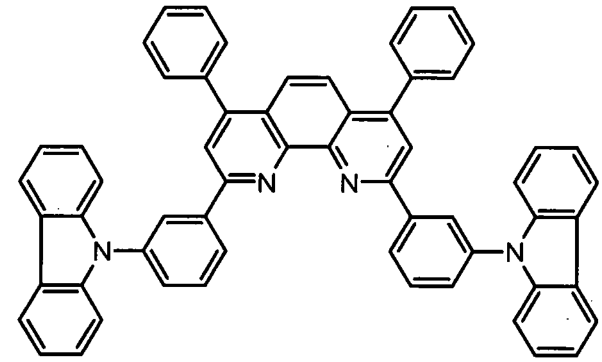

A17:

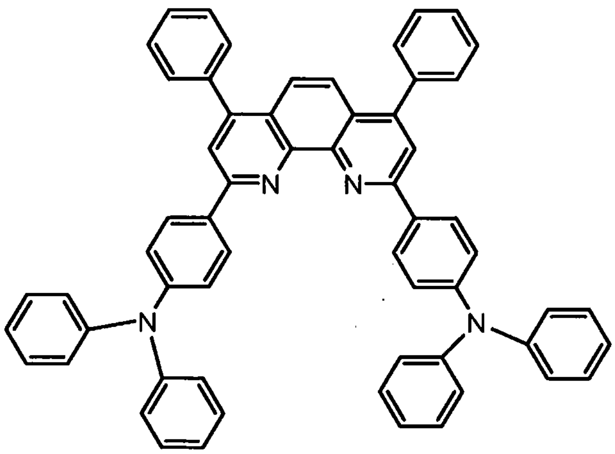

A18:

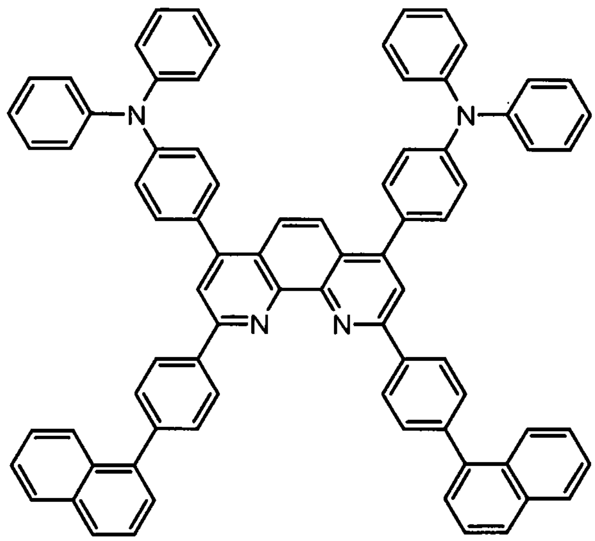

A19:

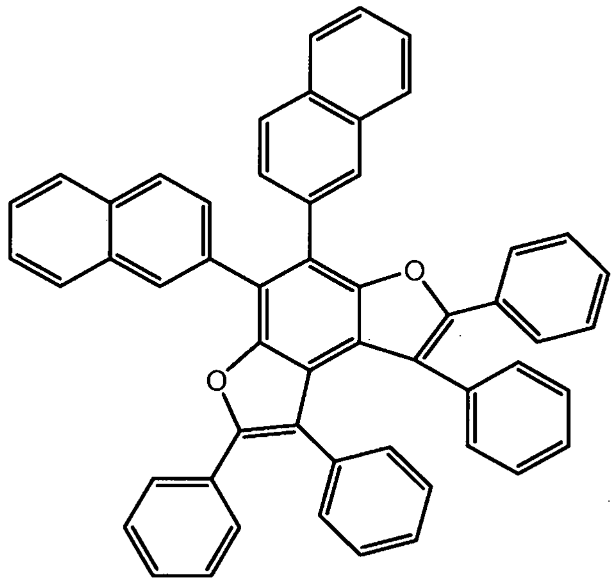

A20:

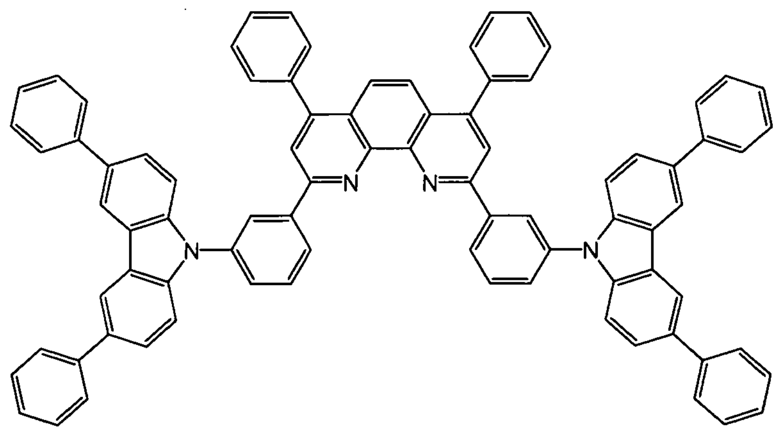

A21:

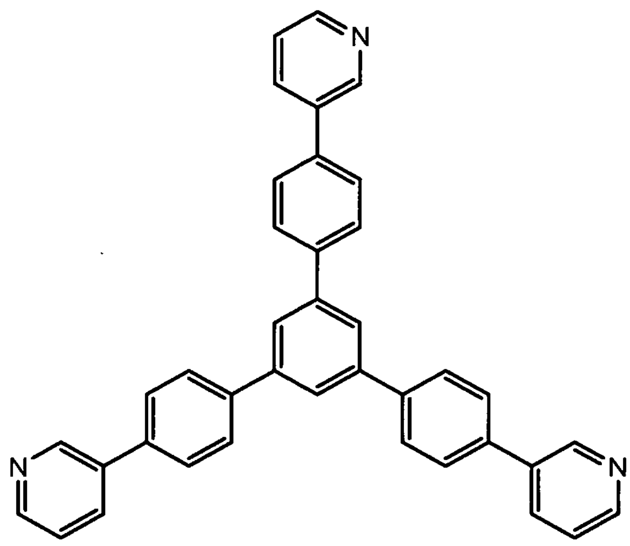

The first materials can be prepared by known coupling and substitution reactions. In some embodiments, the phenanthroline host compounds are made by Suzuki coupling of dichloro phenanthrolines with the boronic acid analog of the desired substituent.

b. Emissive Dopant Materials

Emissive dopant materials include small molecule organic fluorescent compounds, luminescent metal complexes, and mixtures thereof. Examples of fluorescent compounds include, but are not limited to, pyrene, perylene, rubrene, coumarin, derivatives thereof, and mixtures thereof. Examples of metal complexes include, but are not limited to, metal chelated oxinoid compounds, such as tris(8-hydroxyquinolato)aluminum (AlQ); cyclometalated iridium and platinum electroluminescent compounds, such as complexes of iridium with phenylpyridine, phenylquinoline, phenylisoquinoline or phenylpyrimidine ligands as disclosed in Petrov et al., U.S. Patent 6,670,645 and Published PCT Applications WO 03/063555 and WO 2004/016710, and organometallic complexes described in, for example, Published PCT Applications WO 03/008424, WO 03/091688, and WO 03/040257, and mixtures thereof.

In some embodiments, the emissive dopant is an organometallic complex. In some embodiments, the emissive dopant is an organometallic complex of iridium. In some embodiments, the organometallic complex is cyclometallated. By "cyclometallated" it is meant that the complex contains at least one ligand which bonds to the metal in at least two points, forming at least one 5- or 6-membered ring with at least one carbon-metal bond. In some embodiments, the organometallic Ir complex is electrically neutral and is a tris-cyclometallated complex having the formula $IrL_3$ or a bis-cyclometallated complex having the formula $IrL_2Y$. In some embodiments, L is a monoanionic bidentate cyclometalating ligand coordinated through a carbon atom and a nitrogen atom. In some embodiments, L is an aryl N-heterocycle, where the aryl is phenyl or napthyl, and the N-heterocycle is pyridine, quinoline, isoquinoline, diazine, pyrrole, pyrazole or imidazole. In some embodiments, Y is a monoanionic bidentate ligand. In some embodiments, L is a phenylpyridine, a phenylquinoline, or a phenylisoquinoline. In some embodiments, Y is a β-dienolate, a diketimine, a picolinate, or an N-alkoxypyrazole. The ligands may be unsubstituted or substituted with F, D, alkyl, perfluororalkyl, alkoxyl, alkylamino, arylamino, CN, silyl, fluoroalkoxyl or aryl groups.

In some embodiments, the emissive dopant is selected from the group consisting of a non-polymeric spirobifluorene compound and a fluoranthene compound.

In some embodiments, the emissive dopant is a compound having aryl amine groups. In some embodiments, the emissive dopant is selected from the formulae below:

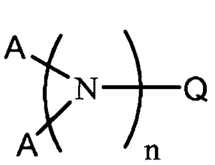

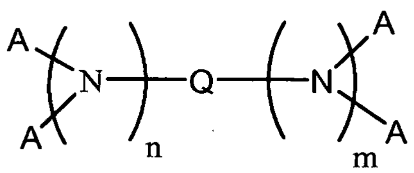

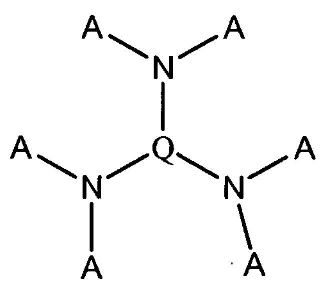

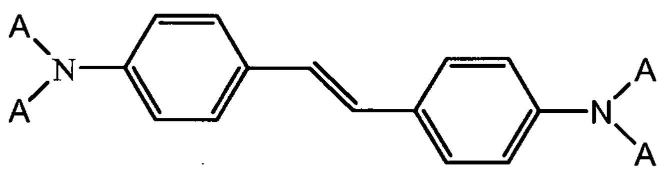

where:

A is the same or different at each occurrence and is an aromatic group having from 3-60 carbon atoms;
Q is a single bond or an aromatic group having from 3-60 carbon atoms;
n and m are independently an integer from 1-6.

In some embodiments of the above formula, at least one of A and Q in each formula has at least three condensed rings. In some embodiments, m and n are equal to 1.

In some embodiments, Q is a styryl or styrylphenyl group.

In some embodiments, Q is an aromatic group having at least two condensed rings. In some embodiments, Q is selected from the group consisting of naphthalene, anthracene, chrysene, pyrene, tetracene, xanthene, perylene, coumarin, rhodamine, quinacridone, and rubrene.

In some embodiments, A is selected from the group consisting of phenyl, tolyl, naphthyl, and anthracenyl groups.

In some embodiments, the emissive dopant has the formula below:

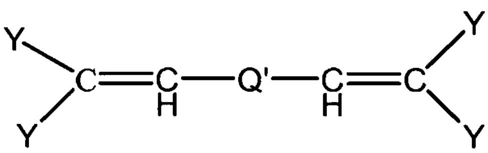

where:

Y is the same or different at each occurrence and is an aromatic group having 3-60 carbon atoms;
Q' is an aromatic group, a divalent triphenylamine residue group, or a single bond.

In some embodiments, the emissive dopant is an aryl acene. In some embodiments, the emissive dopant is a non-symmetrical aryl acene.

In some embodiments, the emissive dopant is a chrysene derivative. The term "chrysene" is intended to mean 1,2-benzophenanthrene. In some embodiments, the emissive dopant is a chrysene having aryl substituents. In some embodiments, the emissive dopant is a chrysene having arylamino substituents. In some embodiments, the emissive dopant is a chrysene having two different arylamino substituents. In some embodiments, the chrysene derivative has a deep blue emission.

In some embodiments, separate photoactive compositions with different dopants are used to provide different colors. In some embodiments, the dopants are selected to have red, green, and blue emission. As used herein, red refers to light having a wavelength maximum in the range of 600-700 nm; green refers to light having a wavelength maximum in the range of 500-600 nm; and blue refers to light having a wavelength maximum in the range of 400-500 nm.

Examples of blue light-emitting materials include, but are not limited to, diarylanthracenes, diaminochrysenes, diaminopyrenes, cyclometalated complexes of Ir having phenylpyridine ligands, and polyfluorene polymers. Blue light-emitting materials have been disclosed in, for example, US patent 6,875,524, and published US applications 2007-0292713 and 2007-0063638.

Examples of red light-emitting materials include, but are not limited to, cyclometalated complexes of Ir having phenylquinoline or phenylisoquinoline ligands, periflanthenes, fluoranthenes, and perylenes. Red light-emitting materials have been disclosed in, for example, US patent 6,875,524, and published US application 2005-0158577.

Examples of green light-emitting materials include, but are not limited to, cyclometalated complexes of Ir having phenylpyridine ligands, diaminoanthracenes, and polyphenylenevinylene polymers. Green light-emitting materials have been disclosed in, for example, published PCT application WO 2007/021117.

Examples of dopant materials include, but are not limited to, compounds B1 to B11 below.

B1

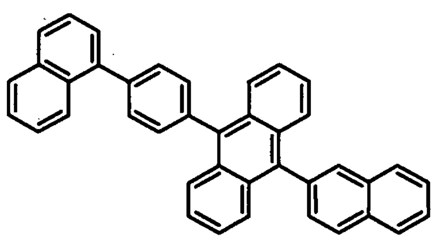

,

B2

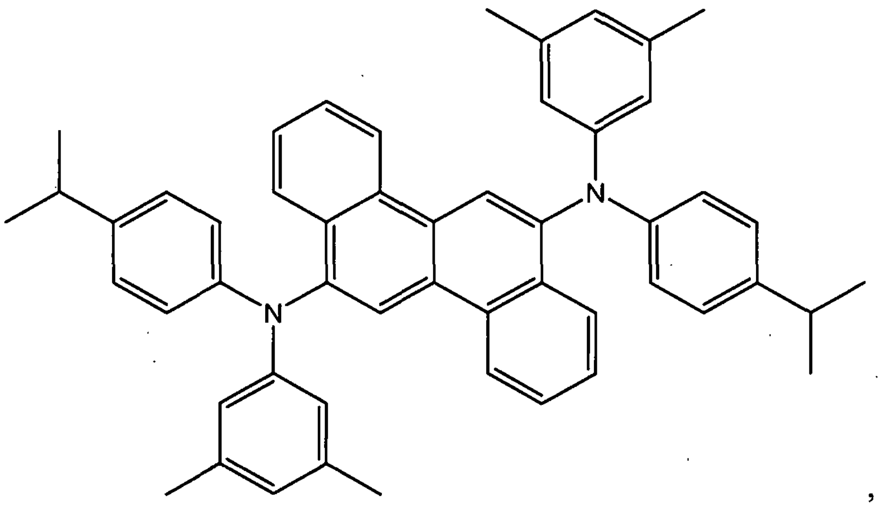

,

B3

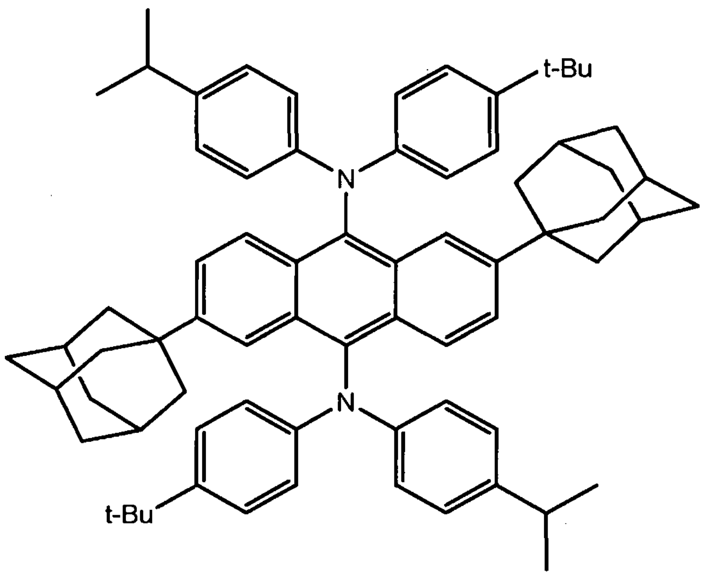

,

B4

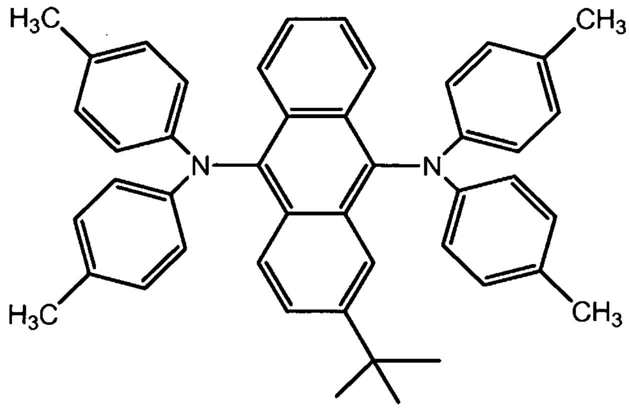

,

B5

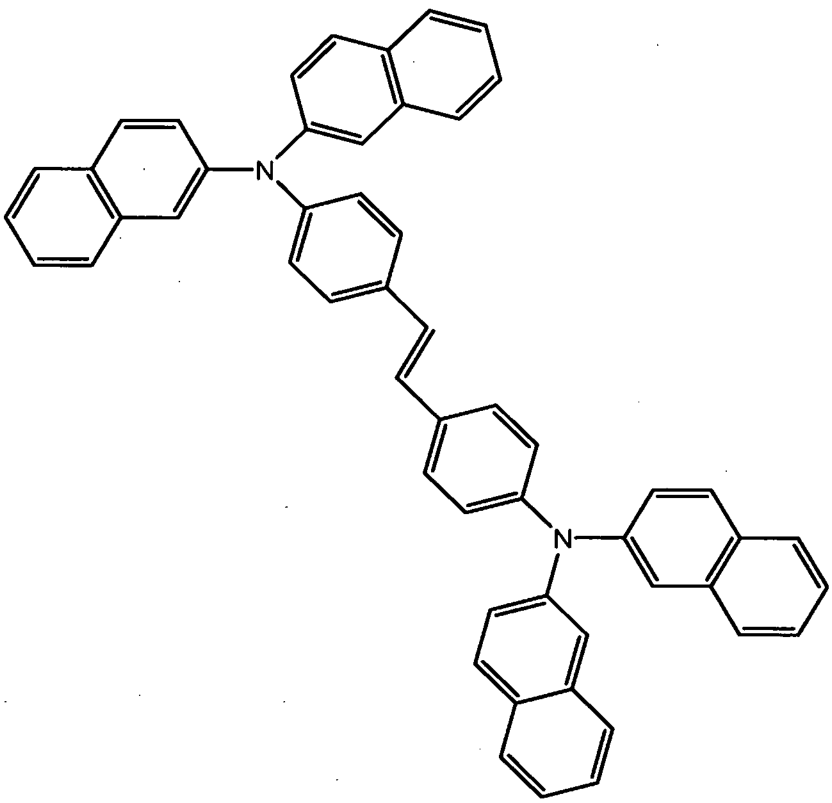

B6

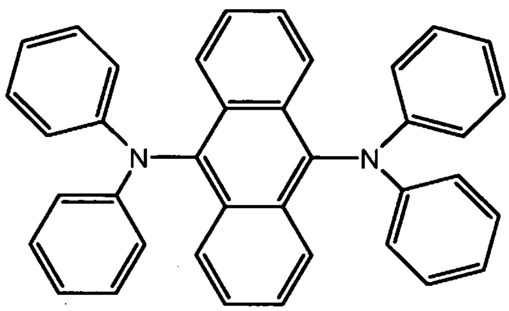

B7

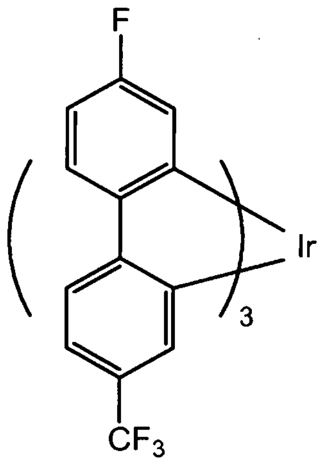

B8

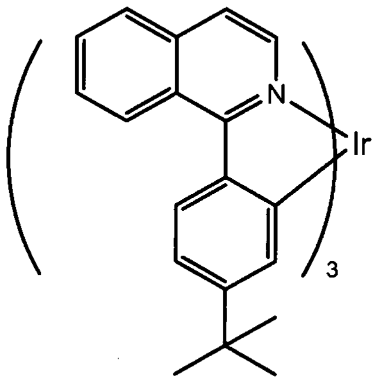

B9

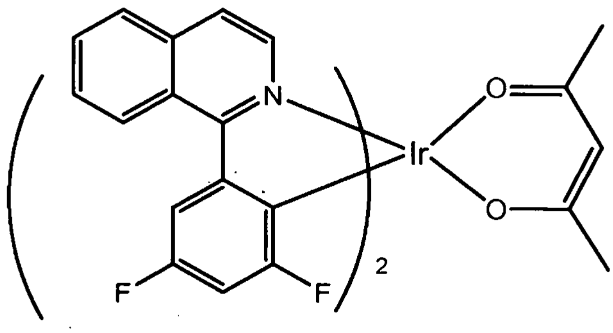

B10

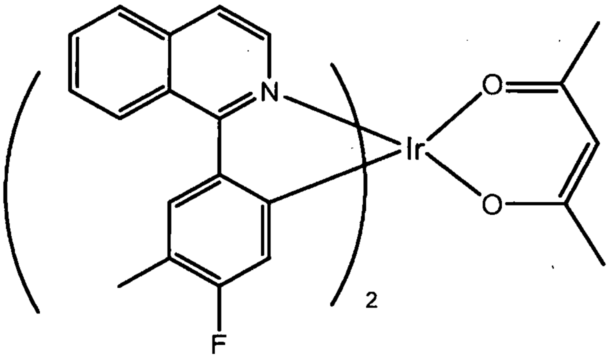

B11

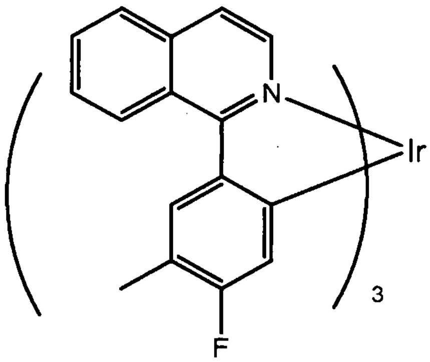

c. Non-Emissive Dopant

The non-emissive dopant is an organometallic iridium complex having a HOMO energy level that is shallower than the HOMO energy level of the host material. When more than one host material is present, the HOMO energy level of the non-emissive dopant is shallower than the HOMO energy level of each of the host materials. By "non-emissive" it is meant that substantially none of the light emission (or reception) is due to the non-emissive dopant. The color of emission (or reception) from the emissive dopant is substantially unchanged by the addition of the non-emissive dopant. In some embodiments, the C.I.E. coordinates for the color of emission from the emissive dopant change by less than 0.015 units, according to the C.I.E. chromaticity scale (Commission Internationale de L'Eclairage, 1931). In some embodiments, the C.I.E. coordinates change by less than 0.010 units.

In some embodiments, the organometallic Ir complex is electrically neutral and is a cyclometallated complex. In some embodiments, the cyclometallated iridium complex is a tris-cyclometallated complex having the formula $IrL_3$ or a bis-cyclometallated complex having the formula $IrL_2Y$. In some embodiments, L is a monoanionic bidentate cyclometalating ligand coordinated through a carbon atom and a nitrogen atom. In some embodiments, L is an aryl N-heterocycle, where the aryl is phenyl or napthyl, and the N-heterocycle is pyridine, quinoline, isoquinoline, diazine, pyrrole, pyrazole or imidazole. In some embodiments, Y is a monoanionic bidentate ligand. In some embodiments, L is a phenylpyridine, a phenylquinoline, or a phenylisoquinoline. In some embodiments, Y is a β-dienolate, a diketimine, a picolinate, or an N-alkoxypyrazole. The ligands may be unsubstituted or substituted with F, D, alkyl, perfluororalkyl, alkoxyl, alkylamino, arylamino, CN, silyl, fluoroalkoxyl or aryl groups.

The choice of non-emissive dopant will depend on the emissive dopant used. The non-emissive dopant will have a wider band gap than the emissive dopant. In some embodiments, the non-emissive dopant will have a higher triplet energy than the emissive dopant.

Some examples of non-emissive dopants include, but are not limited to, compounds C1 to C14 below.

C1:

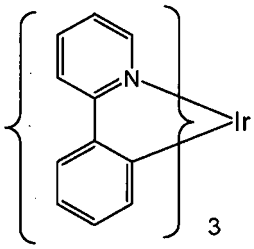

HOMO = -5.17eV

C2:

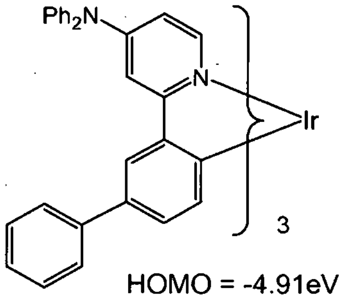

HOMO = -4.91eV

C3:

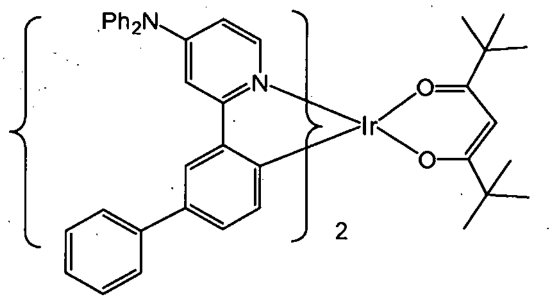

HOMO = -4.84eV

C4:

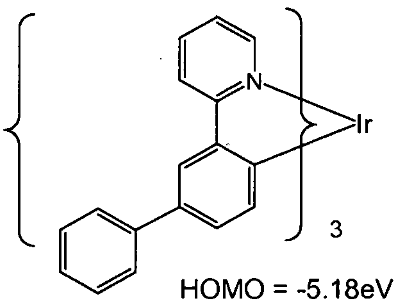

HOMO = -5.18eV

C5:

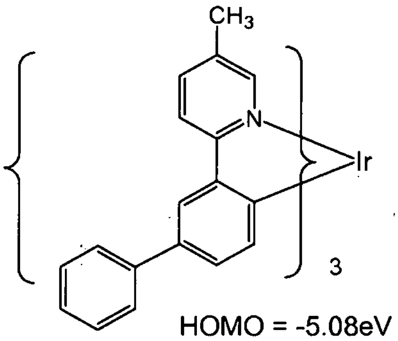

HOMO = -5.08eV

C6:

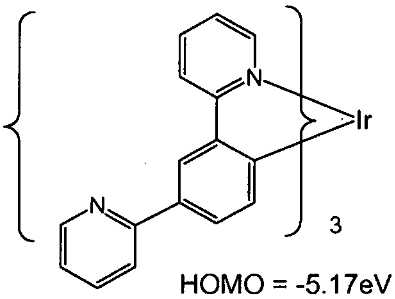

HOMO = -5.17eV

C7:

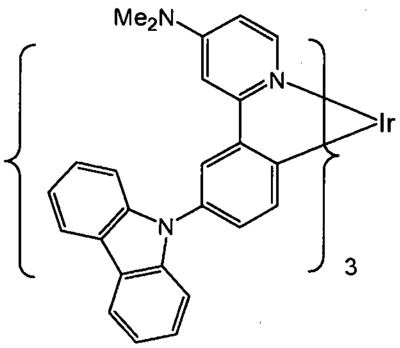

HOMO = -4.94eV

C8:

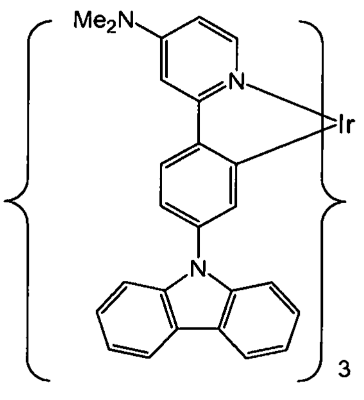

HOMO = -4.91eV

C9:

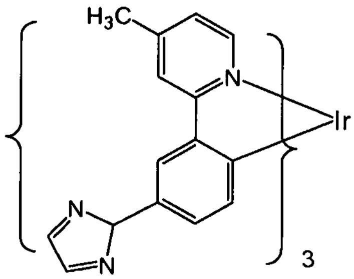

HOMO = -5.03eV

C10:

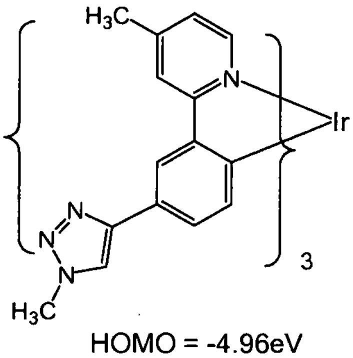

HOMO = -4.96eV

C11:

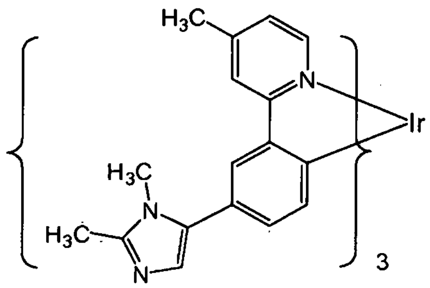

HOMO = -5.06eV

C12:

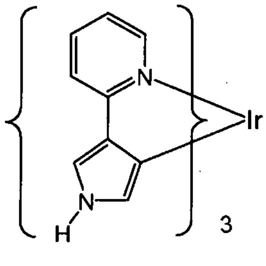

HOMO = -4.48 eV

C13:

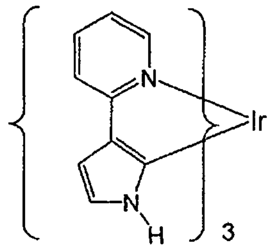

HOMO = -4.77 eV

C14:

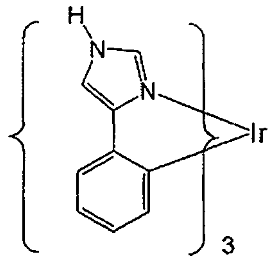

HOMO = -4.68 eV

The non-emissive dopants listed above are particularly suitable for use with red emissive dopants.

The non-emissive dopant can be synthesized according to known procedures for preparing organometallic iridium complexes. Exemplary preparations have been described in, for example, U.S. Patents 6,670,645, 6,870,054, and 7,005,522; and in Published PCT Applications WO 2003/063555, WO 2004/016710, WO 2003/008424, WO 2003/091688, and WO 2003/040257.

Second Host Material

Two hosts are present. In some embodiments, the second host material also has a triplet energy level greater than 2.0 eV. This is particularly useful when the dopant is a phosphorescent material in order to prevent quenching of the emission. In some embodiments, both the first host material and the second host material have a triplet energy level greater than 2.0 eV.

In some embodiments, the second host material is one having a LUMO deeper than -2.0 eV. The LUMO can be determined using inverse photoelectron spectroscopy ("IPES"). In some embodiments, the LUMO of the second host material has a value similar to that of the LUMO of the emissive dopant.

In some embodiments, the first host facilitates hole transport faster than electron transport and is referred to as a hole-transporting host; and the second host facilitates electron transport faster than hole transport and is referred to as an electron-transporting host. In some embodiments, the weight ratio of the hole-transporting first host material to the electron-transporting second host material is in the range of 19:1 to 2:1; in some embodiments, 9:1 to 2.3:1. In some embodiments, the electron-transporting second host is a phenanthroline, a quinoxaline, a phenylpyridine, a benzodifuran, or a metal quinolinate complex.

<u>3. Electronic Device</u>

Organic electronic devices that may benefit from having the photoactive composition described herein include, but are not limited to, (1) devices that convert electrical energy into radiation (e.g., a light-emitting diode, light emitting diode display, or diode laser), (2) devices that detect signals through electronics processes (e.g., photodetectors, photoconductive cells, photoresistors, photoswitches, phototransistors, phototubes, IR detectors, biosensors), (3) devices that convert radiation into electrical energy, (e.g., a photovoltaic device or solar cell), and (4) devices that include one or more electronic components that include one or more organic semi-conductor layers (e.g., a transistor or diode).

In some embodiments, an electronic device comprises:

an anode;
a hole transport layer;
a photoactive layer;
an electron transport layer, and
a cathode;

wherein the photoactive layer comprises the composition described above.

One illustration of an organic electronic device structure is shown in FIG. 2. The device 100 has a first electrical contact layer, an anode layer 110 and a second electrical contact layer, a cathode layer 160, and a photoactive layer 140 between them. Adjacent to the anode is a hole injection layer 120. Adjacent to the hole injection layer is a hole transport layer 130, comprising hole transport material. Adjacent to the cathode may be an electron transport layer 150, comprising an electron transport material. As an option, devices may use one or more additional hole injection or hole transport layers (not shown) next to the anode 110 and/or one or more additional electron injection or electron transport layers (not shown) next to the cathode 160.

In some embodiments, in order to achieve full color, the light-emitting layer is pixellated, with subpixel units for each of the different colors. An illustration of a pixellated device is shown in FIG. 3. The device 200 has anode 210, hole injection layer 220, hole transport layer 230, electroluminescent layer 240, electron transport layer 250, and cathode 260. The electroluminescent layer is divided into subpixels 241, 242, 243, which are repeated across the layer. In some embodiments, the subpixels represent red, blue and green color emission. Although three different subpixel units are depicted in FIG. 3, two or more than three subpixel units may be used.

Layers 120 through 150 in FIG. 2, and layers 220 through 250 in FIG. 3, are individually and collectively referred to as the active layers.

The different layers will be discussed further herein with reference to FIG. 2. However, the discussion applies to FIG. 3 and other configurations as well.

In one embodiment, the different layers have the following range of thicknesses: anode 110, 500-5000 Å, in one embodiment 1000-2000 Å; hole injection layer 120, 50-2000 Å, in one embodiment 200-1000 Å; hole transport layer 130, 50-2000 Å, in one embodiment 200-1000 Å; photoactive layer 140, 10-2000 Å, in one embodiment 100-1000 Å; layer 150, 50-2000 Å, in one embodiment 100-1000 Å; cathode 160, 200-10000 Å, in one embodiment 300-5000 Å. The location of the electron-hole recombination zone in the device, and thus the emission spectrum of the device, can be affected by the relative thickness of each layer. The desired ratio of layer thicknesses will depend on the exact nature of the materials used.

Depending upon the application of the device 100, the photoactive layer 140 can be a light-emitting layer that is activated by an applied voltage (such as in a light-emitting diode or light-emitting electrochemical cell), or a layer of material that responds to radiant energy and generates a signal with or without an applied bias voltage (such as in a photodetector). Examples of photodetectors include photoconductive cells, photoresistors, photoswitches, phototransistors, and phototubes, and photovoltaic cells, as these terms are described in Markus, John, Electronics and Nucleonics Dictionary, 470 and 476 (McGraw-Hill, Inc. 1966).

a. Photoactive layer

The photoactive layer comprises the photoactive composition described above.

In some embodiments, the first host material is a chrysene derivative having at least one diarylamino substituent. In some embodiments, the second host material is a phenanthroline derivative. In some embodiments, these two host materials are used in combination with an emissive dopant which is an organometallic Ir complex.

In some embodiments, the photoactive composition comprises a first host material which is a chrysene derivative having at least one diarlyamino substituent, a second host material which is a phenanthroline derivative, an emissive dopant which is an organometallic Ir complex having red emission, and a non-emissive dopant which is an organometallic Ir complex having a HOMO energy level shallower than the HOMO energy level of the both host materials.

In some embodiments, the photoactive composition consists essentially of a first host material which is a chrysene derivative having at least one diarlyamino substituent, a second host material which is a phenanthroline derivative, an emissive dopant which is a cyclometalated Ir complex having red emission, and a non-emissive dopant which is a cyclometalated Ir complex having a HOMO energy level shallower than the HOMO energy level of the both host materials.

The photoactive layer can be formed by liquid deposition from a liquid composition, as described below. In some embodiments, the photoactive layer is formed by vapor deposition.

In some embodiments, three different photoactive compositions are applied by liquid deposition to form red, green, and blue subpixels. In some embodiments, each of the colored subpixels is formed using new photoactive compositions as described herein. In some embodiments, the first and second host materials are the same for all of the

colors.

b. Other Device Layers

The other layers in the device can be made of any materials that are known to be useful in such layers.

The anode 110, is an electrode that is particularly efficient for injecting positive charge carriers. It can be made of, for example, materials containing a metal, mixed metal, alloy, metal oxide or mixed-metal oxide, or it can be a conducting polymer, or mixtures thereof. Suitable metals include the Group 11 metals, the metals in Groups 4-6, and the Group 8-10 transition metals. If the anode is to be light-transmitting, mixed-metal oxides of Groups 12, 13 and 14 metals, such as indium-tin-oxide, are generally used. The anode 110 can also comprise an organic material such as polyaniline as described in "Flexible light-emitting diodes made from soluble conducting polymer," Nature vol. 357, pp 477-479 (11 June 1992). At least one of the anode and cathode is desirably at least partially transparent to allow the generated light to be observed.

The hole injection layer 120 comprises hole injection material and may have one or more functions in an organic electronic device, including but not limited to, planarization of the underlying layer, charge transport and/or charge injection properties, scavenging of impurities such as oxygen or metal ions, and other aspects to facilitate or to improve the performance of the organic electronic device. Hole injection materials may be polymers, oligomers, or small molecules. They may be vapor deposited or deposited from liquids which may be in the form of solutions, dispersions, suspensions, emulsions, colloidal mixtures, or other compositions.

The hole injection layer can be formed with polymeric materials, such as polyaniline (PANI) or polyethylenedioxythiophene (PEDOT), which are often doped with protonic acids. The protonic acids can be, for example, poly(styrenesulfonic acid), poly(2-acrylamido-2-methyl-1-propanesulfonic acid), and the like.

The hole injection layer can comprise charge transfer compounds, and the like, such as copper phthalocyanine and the tetrathiafulvalene-tetracyanoquinodimethane system (TTF-TCNQ).

In some embodiments, the hole injection layer comprises at least one electrically conductive polymer and at least one fluorinated acid polymer. Such materials have been described in, for example, published U.S. patent applications 2004-0102577, 2004-0127637, and 2005/205860

Examples of hole transport materials for layer 130 have been summarized for example, in Kirk-Othmer Encyclopedia of Chemical Technology, Fourth Edition, Vol. 18, p. 837-860, 1996, by Y. Wang. Both hole transporting molecules and polymers can be used. Commonly used hole transporting molecules are: N,N'-diphenyl-N,N'-bis(3-methylphenyl)-[1,1'-biphenyl]-4,4'-diamine (TPD), 1,1-bis[(di-4-tolylamino) phenyl]cyclohexane (TAPC), N,N'-bis(4-methylphenyl)-N,N'-bis(4-ethylphenyl)-[1,1'-(3,3'-dimethyl)biphenyl]-4,4'-diamine (ETPD), tetrakis-(3-methylphenyl)-N,N,N',N'-2,5-phenylenediamine (PDA), a-phenyl-4-N,N-diphenylaminostyrene (TPS), p-(diethylamino)benzaldehyde diphenylhydrazone (DEH), triphenylamine (TPA), bis[4-(N,N-diethylamino)-2-methylphenyl](4-methylphenyl)methane (MPMP), 1-phenyl-3-[p-(diethylamino)styryl]-5-[p-(diethylamino)phenyl] pyrazoline (PPR or DEASP), 1,2-trans-bis(9H-carbazol-9-yl)cyclobutane (DCZB), N,N,N',N'-tetrakis(4-methylphenyl)-(1,1'-biphenyl)-4,4'-diamine (TTB), N,N'-bis(naphthalen-1-yl)-N,N'-bis-(phenyl)benzidine ($\alpha$-NPB), and porphyrinic compounds, such as copper phthalocyanine. Commonly used hole transporting polymers are polyvinylcarbazole, (phenylmethyl)-polysilane, and polyaniline. It is also possible to obtain hole transporting polymers by doping hole transporting molecules such as those mentioned above into polymers such as polystyrene and polycarbonate. In some cases, triarylamine polymers are used, especially triarylamine-fluorene copolymers. In some cases, the polymers and copolymers are crosslinkable. In some embodiments, the hole transport layer further comprises a p-dopant. In some embodiments, the hole transport layer is doped with a p-dopant. Examples of p-dopants include, but are not limited to, tetrafluorotetracyanoquinodimethane (F4-TCNQ) and perylene-3,4,9,10-tetracarboxylic-3,4,9,10-dianhydride (PTCDA).

Examples of electron transport materials which can be used for layer 150 include, but are not limited to, metal chelated oxinoid compounds, including metal quinolate derivatives such as tris(8-hydroxyquinolato)aluminum (AlQ), bis(2-methyl-8-quinolinolato)(p-phenylphenolato) aluminum (BAlq), tetrakis-(8-hydroxyquinolato)hafnium (HfQ) and tetrakis-(8-hydroxyquinolato)zirconium (ZrQ); and azole compounds such as 2- (4-biphenylyl)-5-(4-t-butylphenyl)-1,3,4-oxadiazole (PBD), 3-(4-biphenylyl)-4-phenyl-5-(4-t-butylphenyl)-1,2,4-triazole (TAZ), and 1,3,5-tri(phenyl-2-benzimidazole)benzene (TPBI); quinoxaline derivatives such as 2,3-bis(4-fluorophenyl)quinoxaline; phenanthrolines such as 4,7-diphenyl-1,10-phenanthroline (DPA) and 2,9-dimethyl-4,7-diphenyl-1,10-phenanthroline (DDPA); and mixtures thereof. In some embodiments, the electron transport layer further comprises an n-dopant. Examples of n-dopants include, but are not limited to Cs and other alkali metals,

The cathode 160, is an electrode that is particularly efficient for injecting electrons or negative charge carriers. The cathode can be any metal or nonmetal having a lower work function than the anode. Materials for the cathode can be selected from alkali metals of Group 1 (e.g., Li, Cs), the Group 2 (alkaline earth) metals, the Group 12 metals, including the rare earth elements and lanthanides, and the actinides. Materials such as aluminum, indium, calcium, barium, samarium and magnesium, as well as combinations, can be used. Li-containing organometallic compounds, LiF, and

$Li_2O$ can also be deposited between the organic layer and the cathode layer to lower the operating voltage.

It is known to have other layers in organic electronic devices. For example, there can be a layer (not shown) between the anode 110 and hole injection layer 120 to control the amount of positive charge injected and/or to provide band-gap matching of the layers, or to function as a protective layer. Layers that are known in the art can be used, such as copper phthalocyanine, silicon oxy-nitride, fluorocarbons, silanes, or an ultra-thin layer of a metal, such as Pt. Alternatively, some or all of anode layer 110, active layers 120, 130, 140, and 150, or cathode layer 160, can be surface-treated to increase charge carrier transport efficiency. The choice of materials for each of the component layers is preferably determined by balancing the positive and negative charges in the emitter layer to provide a device with high electroluminescence efficiency.

It is understood that each functional layer can be made up of more than one layer.

c. Device Fabrication

The device layers can be formed by any deposition technique, or combinations of techniques, including vapor deposition, liquid deposition, and thermal transfer. Substrates such as glass, plastics, and metals can be used. Conventional vapor deposition techniques can be used, such as thermal evaporation, chemical vapor deposition, and the like. The organic layers can be applied from solutions or dispersions in suitable solvents, using conventional coating or printing techniques, including but not limited to spin-coating, dip-coating, roll-to-roll techniques, ink-jet printing, continuous nozzle printing, screen-printing, gravure printing and the like.

In some embodiments, the process for making an organic light-emitting device, comprises:

providing a substrate having a patterned anode thereon;
forming a hole transport layer by depositing a liquid composition comprising a hole transport material in a first liquid medium;
forming a photoactive layer by depositing a liquid composition comprising (a) a first host material having a HOMO energy level shallower than or equal to -5.6 eV and having a Tg greater than 95°C; (b) a second host material having a LUMO deeper than - 2.0 eV; and (c) an electroluminescent dopant material; and (d) a second liquid medium, wherein the weight ratio of first host material to second host material is in the range of 99:1 to 1.5:1;
forming an electron transport layer by vapor deposition of an electron transport material; and
forming a cathode overall.

The term "liquid composition" is intended to mean a liquid medium in which a material is dissolved to form a solution, a liquid medium in which a material is dispersed to form a dispersion, or a liquid medium in which a material is suspended to form a suspension or an emulsion.

Any known liquid deposition technique or combination of techniques can be used, including continuous and discontinuous techniques. Examples of continuous liquid deposition techniques include, but are not limited to spin coating, gravure coating, curtain coating, dip coating, slot-die coating, spray coating, and continuous nozzle printing. Examples of discontinuous deposition techniques include, but are not limited to, ink jet printing, gravure printing, and screen printing. In some embodiments, the photoactive layer is formed in a pattern by a method selected from continuous nozzle coating and ink jet printing. Although the nozzle printing can be considered a continuous technique, a pattern can be formed by placing the nozzle over only the desired areas for layer formation. For example, patterns of continuous rows can be formed.

A suitable liquid medium for a particular composition to be deposited can be readily determined by one skilled in the art. For some applications, it is desirable that the compounds be dissolved in non-aqueous solvents. Such non-aqueous solvents can be relatively polar, such as $C_1$ to $C_{20}$ alcohols, ethers, and acid esters, or can be relatively non-polar such as $C_1$ to $C_{12}$ alkanes or aromatics such as toluene, xylenes, trifluorotoluene and the like. Another suitable liquid for use in making the liquid composition, either as a solution or dispersion as described herein, comprising the new compound, includes, but not limited to, a chlorinated hydrocarbon (such as methylene chloride, chloroform, chlorobenzene), an aromatic hydrocarbon (such as a substituted or non-substituted toluene or xylenes, including trifluorotoluene), a polar solvent (such as tetrahydrofuran (THF), N-methyl pyrrolidone (NMP)), an ester (such as ethylacetate), an alcohol (such as isopropanol), a ketone (such as cyclopentatone), or any mixture thereof. Examples of mixtures of solvents for light-emitting materials have been described in, for example, published US application 2008-0067473.

In some embodiments, the weight ratio of total host material (first host together with second host) to the dopant is in the range of 5:1 to 25:1.

After deposition, the material is dried to form a layer. Any conventional drying technique can be used, including heating, vacuum, and combinations thereof.

In some embodiments, the device is fabricated by liquid deposition of the hole injection layer, the hole transport layer, and the photoactive layer, and by vapor deposition of the anode, the electron transport layer, an electron injection layer and the cathode.

EXAMPLES

The concepts described herein will be further described in the following examples, which do not limit the scope of the invention described in the claims.

Example 1

This example illustrates the preparation of host material A11.

a. Preparation of 3-Bromochrysene.

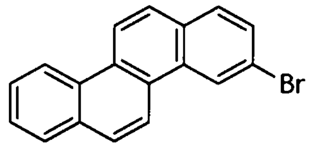

(i) Preparation of 1-(4-bromostyryl)naphthalenes

An oven-dried two-liter four-neck round-bottom flask was equipped with a magnetic stir bar, addition funnel, thermometer adapter and nitrogen inlet and charged (1-napthylmethyl)triphenylphosphonium chloride (49.87 g, 113.6 mmol) and dry THF (970 ml). The slurry was cooled to -5 °C and n-BuLi (50 ml, 125 mmol, 2.5 M solution) was added *via* addition funnel over the period of 25 min. Residual n-BuLi was washed out of the addition funnel with 10 mL of THF. A very dark red solution formed and was left to stir for 15 min. Reaction mixture was then cooled to -75 °C and 4-bromobenzaldehyde (21.0 g, 113.6 mmol) dissolved in dry THF (ca. 75 ml) was added dropwise over 30 min, keeping the temp at -75°C. Residual aldehyde was washed out of the addition funnel with 20 mL of THF. Reaction mixture was left in the cold bath to gradually warm up to rt while stirring overnight. Next day, reaction was quenched with water (30 ml) and volatiles were removed on the rotavap. Residue was stirred in 500 ml of hexane and then filtered. Solids were washed with hexane. Filtrate was concentrated to give crude product which was purified by column chromatography (0-100% $CH_2Cl_2$ in hexanes). Yield 17.7g (50%). Structure was confirmed by $^1$H NMR spectroscopy.

(ii) Preparation of 3-bromochrysene

1-(4-Bromostyryl)naphthalenes (5.0 g, 16.2 mmol) were dissolved in dry toluene (1 l) in a one-liter photochemical vessel, equipped with nitrogen inlet and a stir bar. A bottle of dry propylene oxide was cooled in ice-water before 100 ml of the epoxide was withdrawn with a syringe and added to the reaction mixture. Iodine (4.2 g, 16.5 mmol) was added last. Condenser was attached on top of the photochemical vessel and halogen lamp (Hanovia, 450W) was turned on. Reaction was stopped by turning off the lamp when no more iodine was left in the reaction mixture, as evidenced by the disappearance of its color. The reaction was complete in two hours. Toluene and excess propylene oxide were removed under reduced pressure to yield a dark yellow solid. Crude product was washed with diethyl ether to give 3.4 g (68 %) of 3-bromochrysene as an off-white solid. Structure was confirmed by $^1$H NMR spectroscopy.

b. Preparation of N-([1,1'-biphenyl]-4-yl)-[1,1':3',1"-terphenyl]-4-amine.

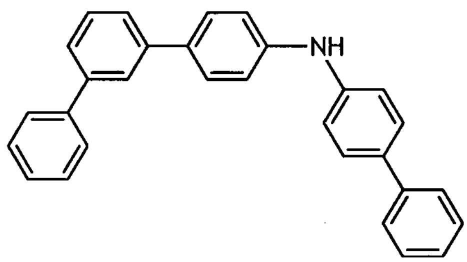

In a drybox, 4-aminobiphenyl (0.542 g) and 4-bromo-1,1':3',1"-terphenyl (0.89 g) were combined in a round-bottom flask and dissolved in 10 ml of dry toluene. Tris(tert-butyl)phosphine (0.022 g, 0.11 mmol) and tris(dibenzylideneacetone) dipalladium(0) (0.05 g, 0.055 mmol) were dissolved in 10 ml of dry toluene and stirred for 5 minutes. The catalyst solution was added to the reaction mixture, stirred for 2 minutes and was followed by sodium tert-butoxide (0.32 g, 3.3 mmol). Flask was capped and left to stir in the drybox overnight at room temperature. Next day, reaction mixture was taken out of the box and filtered through a one-inch plug of silica gel topped with celite, washing with 500 ml of dichloromethane. Removal of volatiles under reduced pressure gave a yellow solid. Crude product was purified by trituration with diethyl ether to give 0.85 g (73%) of a white solid. Structure was confirmed by $^1$H NMR spectroscopy.

c. Preparation of A11

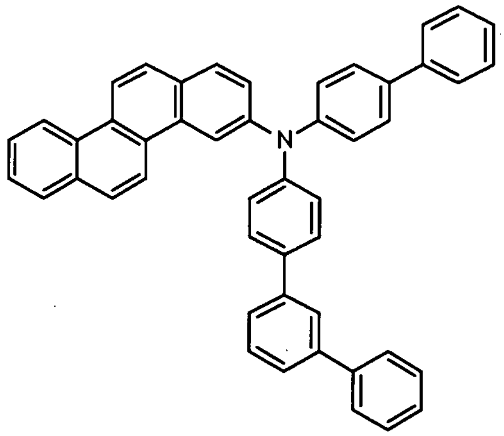

In a drybox, N-([1,1'-biphenyl]-4-yl)-[1,1':3',1"-terphenyl]-4-amine (2.02 mmol) and 3-bromochrysene (1.85 mmol) were combined in a thick-walled glass tube and dissolved in 20 ml of dry toluene. Tris(tert-butyl)phosphine (7.5 mg, 0.037 mmol) and tris(dibenzylideneacetone) dipalladium(0) (17 mg, 0.019 mmol) were dissolved in 10 ml of dry toluene and stirred for 10 minutes. The catalyst solution was added to the reaction mixture, stirred for 5 minutes and followed by sodium tert-butoxide (0.194 g, 2.02 mmol) and 20 ml of dry toluene. After another 10 minutes, the reaction flask was brought out of the drybox and placed into an 80 °C bath to stir overnight. Next day, reaction mixture was cooled to room temperature and filtered through a three-inch plug of silica gel and topped with half an inch of Celite, washing with 400 ml of chloroform. Removal of volatiles under reduced pressure gave a yellow solid. Crude product was purified by column chromatography with chloroform in hexane. Yield 1.05g (87.5%) of a white solid. Identity and purity of the product were established by $^1$H NMR, mass spectrometry and liquid chromatography. The properties of the compound are given in Table 1.

<u>Example 2</u>

This example illustrates the preparation of host compound A20 using Suzuki coupling of 2,9-dichloro-4,7-diphenyl-1,10-phenanthroline from Example 1 with the boronic ester shown below.

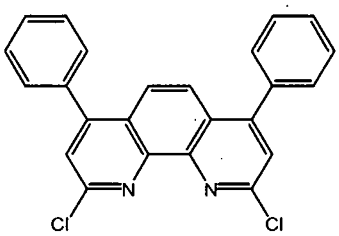
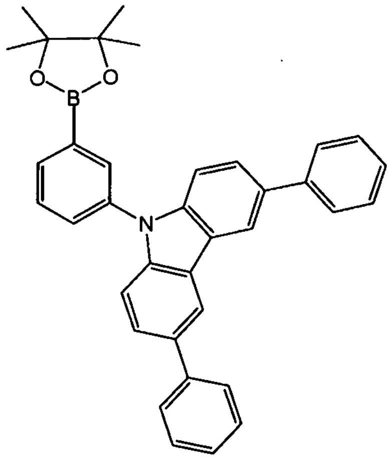

Take 1.0g of dichloro-phen (2.5mM) in glove box and add 3.12g (6mM) boronic ester. Add 0.15g Pd2DBA3 (0.15mM), 0.1g tricyclohexylphosphine (0.35mM) and 2.0g potassium phosphate (9mM) and dissolve all into 30mL dioxane and 15mL water. Mix and heat in glove box in mantle at 100C for 1 hr then warm gently (minimum rheostat setting) under nitrogen overnight. Solution immediately is dark purple but on reaching ~80C it is a tan brown slurry which slowly becomes clear brown with a dense ppt. As the solution refluxes (air condensor) a brown gummy material forms. Cool and work up by removing from glove box and add water. Extract into DCM and dry over magnesium sulfate. Chromatograph on a plug of silica/florisil eluting with DCM then DCM/methanol 2:1. Collect a pale yellow solution which was evaporated and upon addition of methanol ppts a white/pale yellow solid. The structure was confirmed by NMR analysis to be Compound A20:

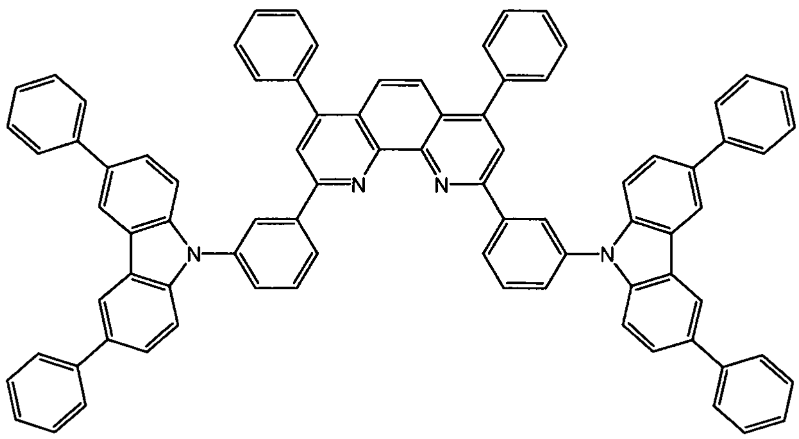

Compound A20

Example 3

Emissive dopant compound B11 and non-emissive dopant compound C5 were prepared using a procedure similar to that described in US Patent 6,670,645.

Examples 4-6 and Comparative Example A

These examples demonstrate the fabrication and performance of OLED devices. The following materials were used:

Indium Tin Oxide (ITO): 50 nm

hole injection layer = HIL-1 (50 nm), which is an aqueous dispersion of an electrically conductive polymer and a polymeric fluorinated sulfonic acid. Such materials have been described in, for example, published U.S. patent applications US 2004/0102577, US 2004/0127637, US 2005/0205860, and published PCT application WO 2009/018009.

hole transport layer = HT-1 (20 nm), which is an arylamine-containing copolymer. Such materials have been described in, for example, published U.S. patent application US 2009/067419.

photoactive layer = host compound A11, host compound A20, emissive dopant B11, and non-emissive dopant C5 were present in the amounts shown in Table 1 (75 nm)

electron transport layer = ET-1 (10 nm), a phenanthroline derivative cathode = CsF/Al (0.7/100 nm)

OLED devices were fabricated by a combination of solution processing and thermal evaporation techniques. Patterned indium tin oxide (ITO) coated glass substrates from Thin Film Devices, Inc were used. These ITO substrates are based on Corning 1737 glass coated with ITO having a sheet resistance of 30 ohms/square and 80% light transmission. The patterned ITO substrates were cleaned ultrasonically in aqueous detergent solution and rinsed with distilled water. The patterned ITO was subsequently cleaned ultrasonically in acetone, rinsed with isopropanol, and dried in a stream of nitrogen.

Immediately before device fabrication the cleaned, patterned ITO substrates were treated with UV ozone for 10 minutes. Immediately after cooling, an aqueous dispersion of HIJ-1 was spin-coated over the ITO surface and heated to remove solvent. After cooling, the substrates were then spin-coated with a solution of HT-1, and then heated to remove solvent. A photoactive layer solution was formed by dissolving the host(s) and dopants, described in Table 1, in toluene. After cooling, the substrates were spin-coated with the emissive layer solution, and heated to remove solvent. The substrates were masked and placed in a vacuum chamber. The electron transport layer was deposited by thermal evaporation, followed by a layer of CsF. Masks were then changed in vacuo and a layer of Al was deposited by thermal evaporation. The chamber was vented, and the devices were encapsulated using a glass lid, dessicant, and UV curable epoxy.

The OLED samples were characterized by measuring their (1) current-voltage (I-V) curves, (2) electroluminescence radiance versus voltage, and (3) electroluminescence spectra versus voltage. All three measurements were performed at the same time and controlled by a computer. The current efficiency of the device at a certain voltage is determined by dividing the electroluminescence radiance of the LED by the current density needed to run the device. The unit is a cd/A. The power efficiency is the current efficiency divided by the operating voltage. The unit is lm/W. The results are given in Table 2.

Table 1. Photoactive Compositions

| Example | Host A11 (wt%) | Host A20 (wt%) | Emissive Dopant B11 (wt%) | Non-Emissive Dopant C5 (wt%) |
|---|---|---|---|---|
| Comp. A | 67 | 25 | 8 | none |
| 4 | 65 | 25 | 8 | 2 |
| 5 | 63 | 25 | 8 | 4 |
| 6 | 59 | 25 | 8 | 8 |

Table 2. Device Results

| Example | EQE % | V | CIEx | CIEy | T50 |
|---|---|---|---|---|---|
| Comp. A | 2.8 | 4.7 | 0.658 | 0.339 | 10,716 |
| 4 | 7.8 | 5.9 | 0.660 | 0.338 | 40,851 |
| 5 | 10.1 | 6.1 | 0.660 | 0.337 | 48,105 |
| 6 | 10.4 | 6.2 | 0.660 | 0.338 | 48,639 |

EQE = external quantum efficiency at 1000 nits; V = voltage at 300 A/$m^2$; CIEx and CIEy are the x and y color coordinates according to the C.I.E. chromaticity scale (Commission Internationale de L'Eclairage, 1931); T50 is the time in hours to reach 50% of initial luminance, calculated using an acceleration factor of 1.7.

It can be seen from Table 2 that the device efficiency and lifetime increase dramatically with the addition of the non-emissive dopant, while the color coordinates remain very nearly the same. The voltage increases somewhat. Thus the amount of non-emissive dopant to be used should be determined by maximizing the efficiency and lifetime improvements without excessive voltage increases.

## Claims

1. A photoactive composition comprising:

(a) 50-99 wt% based on the total weight of the photoactive composition, of at least one first host material having a HOMO energy level;
(b) 1-10 wt% based on the total weight of the photoactive composition, of an emissive dopant;
(c) 0.1 to 10 wt% based on the total weight of the photoactive composition, of a non-emissive dopant, wherein the non-emissive dopant is an organometallic iridium complex having a HOMO energy level shallower than the HOMO energy level of the first host and a wider band gap than the emissive dopant; and
(d) 1-49 wt% based on the total weight of the photoactive composition, of a second host material having a HOMO energy level that is deeper than the HOMO energy level of the non-emissive dopant,
wherein the first host material has Formula I

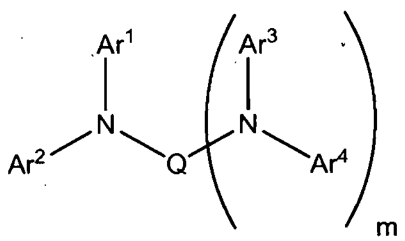

where:

$Ar^1$ to $Ar^4$ are the same or different and are aryl;
Q is chrysene, phenanthrene, triphenylene, phenanthroline, naphthalene, anthracene, quinoline, or isoquinoline; and
m is an integer from 0-6.

2. The composition of Claim 1, wherein the weight ratio of the first host material to the second host material is in the range of 19:1 to 2:1.

3. The composition of Claim 1, wherein at least one material is deuterated.

4. The composition of Claim 1, wherein the first host material has a HOMO energy level deeper than -5.0 eV.

5. The composition of Claim 1, wherein the first host material has a Tg greater than 95°C.

6. The composition of Claim 1, wherein the second host is a phenanthroline, a quinoxaline, a phenylpyridine, a benzodifuran, or a metal quinolinate complex.

7. The composition of Claim 1, wherein the emissive dopant is an organometallic complex of iridium.

8. The composition of Claim 1, wherein the non-emissive dopant has the formula $IrL_3$ or $IrL_2Y$, wherein L is a monoanionic bidentate cyclometalating ligand coordinated through a carbon atom and a nitrogen atom and Y is a monoanionic bidentate ligand.

9. The composition of Claim 1, wherein the non-emissive dopant is one of C1 through C14:

C1:

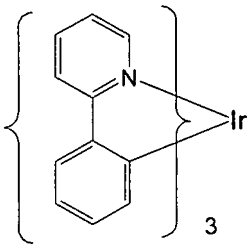

HOMO = -5.17eV

C2:

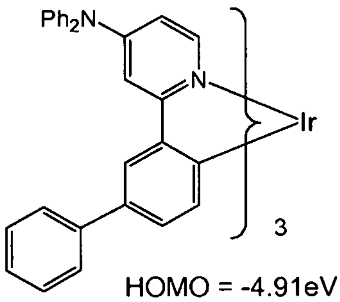

HOMO = -4.91eV

C3:

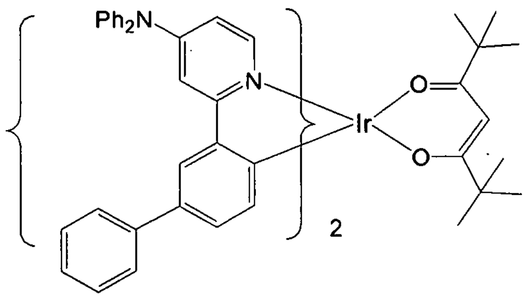

HOMO = -4.84eV

C4:

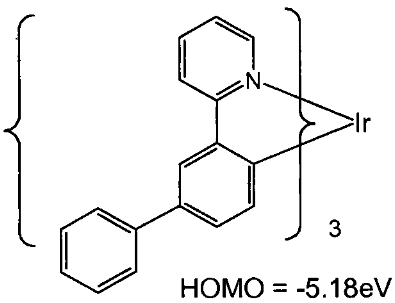

HOMO = -5.18eV

C5:

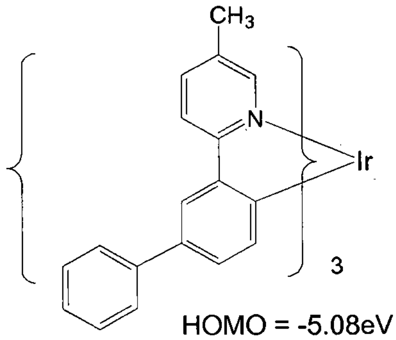

HOMO = -5.08eV

C6:

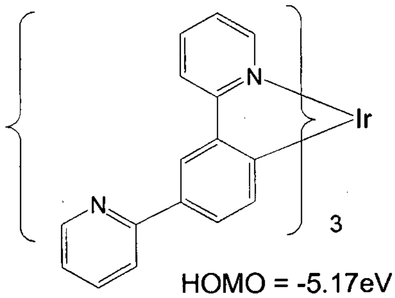

HOMO = -5.17eV

C7:

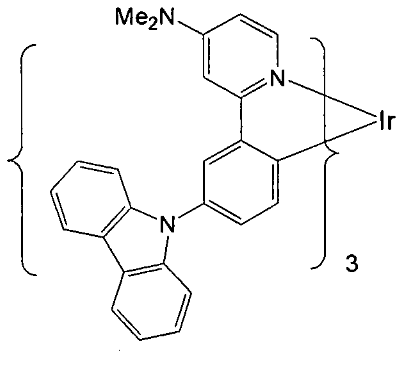

HOMO = -4.94eV

C8:

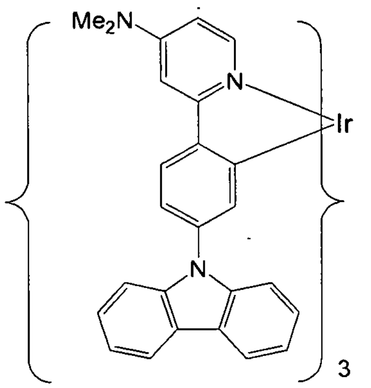

HOMO = -4.91eV

C9:

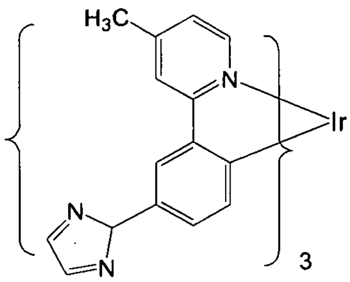

HOMO = -5.03eV

C10:

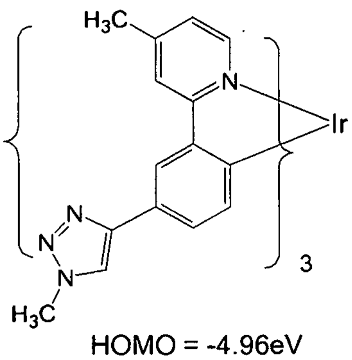

HOMO = -4.96eV

C11:

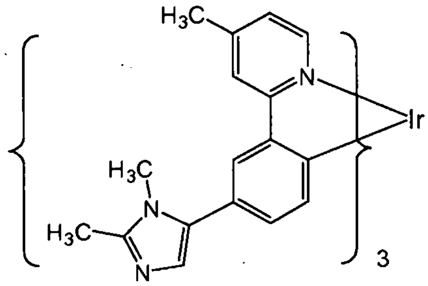

HOMO = -5.06eV

C12:

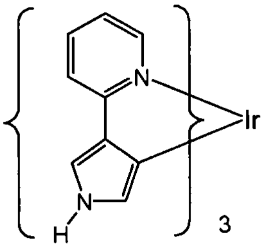

HOMO = -4.48 eV

C13:

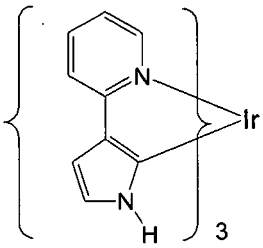

HOMO = -4.77 eV

C14:

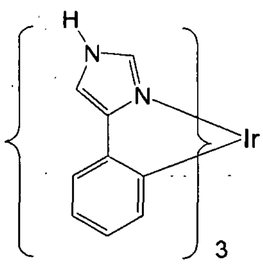

HOMO = -4.68 eV.

**10.** An electronic device comprising:

an anode;

a hole transport layer;
a photoactive layer;
an electron transport layer, and
a cathode;
wherein the photoactive layer comprises:

(a) 50-99 wt% based on the total weight of the photoactive composition, of at least one first host material having a HOMO energy level;
(b) 1-10 wt% based on the total weight of the photoactive composition, of an emissive dopant;
(c) 0.1 to 10 wt% based on the total weight of the photoactive composition, of a non-emissive dopant, wherein the non-emissive dopant is an organometallic iridium complex having a HOMO energy level shallower than the HOMO energy level of the first host and a wider band gap than the emissive dopant; and
(d) 1-49 wt% based on the total weight of the photoactive composition, of a second host material having a HOMO energy level that is deeper than the HOMO energy level of the non-emissive dopant,

wherein the first host material has Formula I

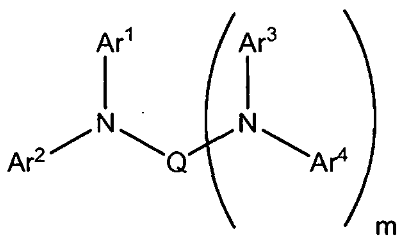

where:

$Ar^1$ to $Ar^4$ are the same or different and are aryl;
Q is chrysene, phenanthrene, triphenylene, phenanthroline, naphthalene, anthracene, quinoline, or isoquinoline; and
m is an integer from 0-6.

**11.** The device of Claim 10, wherein the photoactive composition comprises a first host material which is a chrysene derivative having at least one diarlyamino substituent, a second host material which is a phenanthroline derivative, an emissive dopant which is an organometallic Ir complex having red emission, and a non-emissive dopant which is an organometallic Ir complex having a HOMO energy lever shallower than the HOMO energy level of the both host materials.

**12.** A process for making an organic light-emitting device comprising:

providing a substrate having a patterned anode thereon;
forming a hole transport layer by depositing a liquid composition comprising a hole transport material in a first liquid medium;
forming a photoactive layer by depositing a liquid composition comprising the photoactive composition of any of claims 1-9;
forming an electron transport layer; and
forming a cathode overall.

## Patentansprüche

**1.** Photoaktive Zusammensetzung umfassend:

(a) 50 - 99 Gew.-%, auf das Gesamtgewicht der photoaktiven Zusammensetzung bezogen, mindestens eines ersten Wirtsmaterials, das ein HOMO-Energieniveau aufweist;
(b) 1 - 10 Gew.-%, auf das Gesamtgewicht der photoaktiven Zusammensetzung bezogen, eines emissiven Dotiermittels;

(c) 0,1 bis 10 Gew.-%, auf das Gesamtgewicht der photoaktiven Zusammensetzung bezogen, eines nicht emissiven Dotiermittels, wobei das nicht emissive Dotiermittel ein organometallischer Iridiumkomplex ist, der ein HOMO-Energieniveau, das niedriger als das HOMO-Energieniveau des ersten Wirts ist, und eine breitere Bandlücke als das emissive Dotiermittel aufweist; und
(d) 1 - 49 Gew.-%, auf das Gesamtgewicht der photoaktiven Zusammensetzung bezogen, eines zweiten Wirtsmaterials, das ein HOMO-Energieniveau aufweist, das tiefer als das HOMO-Energieniveau des nicht emissiven Dotiermittels ist,
wobei das erste Wirtsmaterial die Formel I aufweist

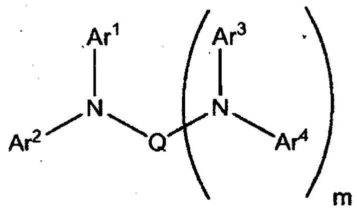

wobei:

$Ar^1$ bis $Ar^4$ gleich oder verschieden und Aryl sind;
Q Chrysen, Phenanthren, Triphenylen, Phenanthrolin, Naphthalin, Anthracen, Chinolin oder Isochinolin ist; und
m eine ganze Zahl von 0 - 6 ist.

2. Zusammensetzung nach Anspruch 1, wobei das Gewichtsverhältnis des ersten Wirtsmaterials zum zweiten Wirtsmaterial im Bereich von 19:1 bis 2:1 liegt.

3. Zusammensetzung nach Anspruch 1, wobei mindestens ein Material deuteriert ist.

4. Zusammensetzung nach Anspruch 1, wobei das erste Wirtsmaterial ein HOMO-Energieniveau aufweist, das tiefer als -5,0 eV ist.

5. Zusammensetzung nach Anspruch 1, wobei das erste Wirtsmaterial eine Tg von über 95 °C aufweist.

6. Zusammensetzung nach Anspruch 1, wobei der zweite Wirt ein Phenanthrolin, ein Chiloxalin, ein Phenylpyridin, ein Benzodifuran oder ein Metallchinolinatkomplex ist.

7. Zusammensetzung nach Anspruch 1, wobei das emissive Dotiermittel ein organometallischer Komplex von Iridium ist.

8. Zusammensetzung nach Anspruch 1, wobei das nicht emissive Dotiermittel die Formel $IrL_3$ oder $IrL_2Y$ aufweist, wobei L ein monoanionischer zweizähniger cyclometallierender Ligand ist, der durch ein Kohlenstoffatom und ein Stickstoffatom koordiniert ist und Y ein monoanionischer zweizähniger Ligand ist.

9. Zusammensetzung nach Anspruch 1, wobei das nicht emissive Dotiermittel eines von C1 bis C14 ist:

C1:

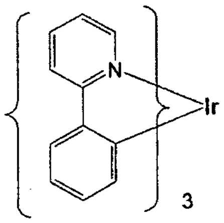

HOMO = -5.17eV

C2:

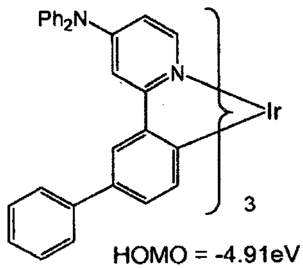

HOMO = -4.91eV

C3:

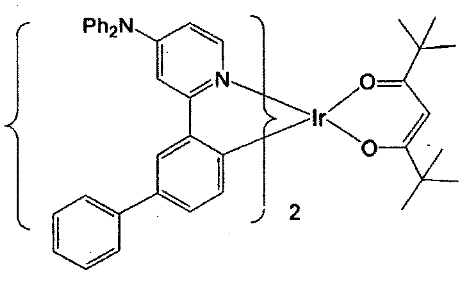

HOMO = -4.84eV

C4:

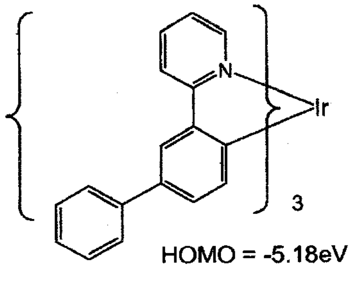

HOMO = -5.18eV

C5:

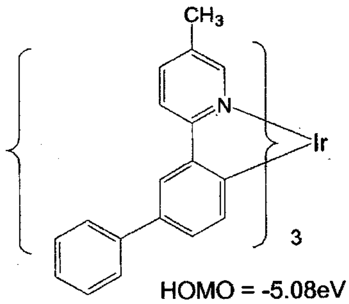

HOMO = -5.08eV

C6:

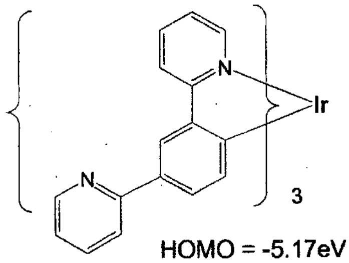

HOMO = -5.17eV

C7:

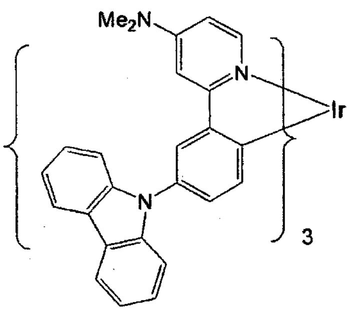

HOMO = -4.94eV

C8:

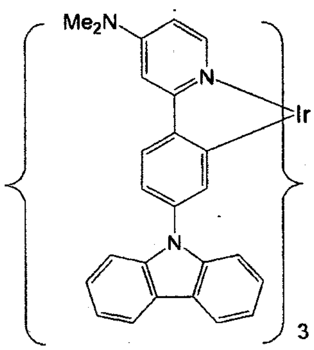

HOMO = -4.91eV

C9:

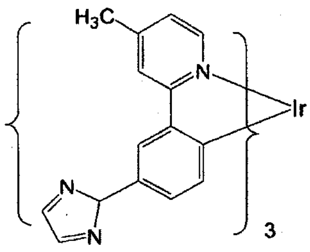

HOMO = -5.03eV

C10:

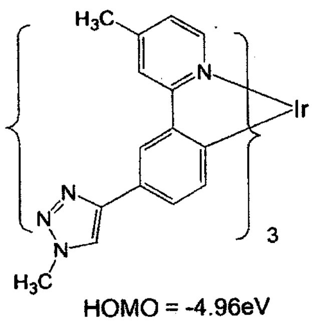

HOMO = -4.96eV

C11:

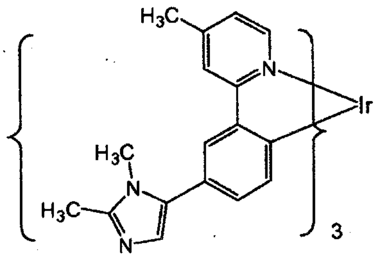

HOMO = -5.06eV

C12:

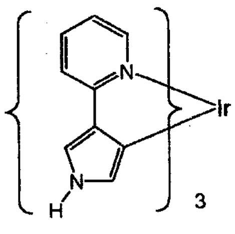

HOMO = -4.48 eV

C13:

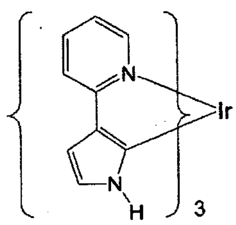

HOMO = -4.77 eV

C14:

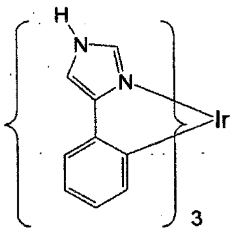

HOMO = -4.68 eV.

**10.** Elektronische Vorrichtung umfassend:

eine Anode;
eine Lochtransportschicht;
eine photoaktive Schicht;
eine Elektronentransportschicht und
eine Kathode;
wobei die photoaktive Schicht Folgendes umfasst:

(a) 50 - 99 Gew.-%, auf das Gesamtgewicht der photoaktiven Zusammensetzung bezogen, mindestens eines ersten Wirtsmaterials, das ein HOMO-Energieniveau aufweist;
(b) 1 - 10 Gew.-%, auf das Gesamtgewicht der photoaktiven Zusammensetzung bezogen, eines emissiven Dotiermittels;
(c) 0,1 bis 10 Gew.-%, auf das Gesamtgewicht der photoaktiven Zusammensetzung bezogen, eines nicht emissiven Dotiermittels, wobei das nicht emissive Dotiermittel ein organometallischer Iridiumcomplex ist, der ein HOMO-Energieniveau, das niedriger als das HOMO-Energieniveau des ersten Wirts ist, und eine breitere Bandlücke als das emissive Dotiermittel aufweist; und
(d) 1 - 49 Gew.-%, auf das Gesamtgewicht der photoaktiven Zusammensetzung bezogen, eines zweiten Wirtsmaterials, das ein HOMO-Energieniveau aufweist, das tiefer als das HOMO-Energieniveau des nicht emissiven Dotiermittels ist,

wobei das erste Wirtsmaterial die Formel I aufweist

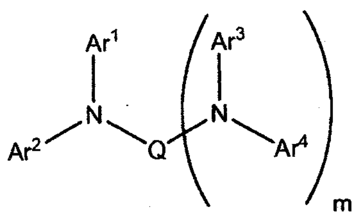

wobei:

$Ar^1$ bis $Ar^4$ gleich oder verschieden und Aryl sind;
Q Chrysen, Phenanthren, Triphenylen, Phenanthrolin, Naphthalin, Anthracen, Chinolin oder Isochinolin ist; und
m eine ganze Zahl von 0 - 6 ist.

**11.** Vorrichtung nach Anspruch 10, wobei die photoaktive Zusammensetzung ein erstes Wirtsmaterial, das ein Chrysenderivat ist, das mindestens einen Diarylaminosubstituenten aufweist, ein zweites Wirtsmaterial, das ein Phenanthrolinderivat ist, ein emissives Dotiermittel, das ein organometallischer Ir-Komplex ist, der eine rote Emission aufweist, und ein nicht emissives Dotiermittel umfasst, das ein organometallischer Ir-Komplex ist, der ein HOMO-Energieniveau aufweist, das niedriger ist als das HOMO-Energieniveau der beiden Wirtsmaterialien.

**12.** Verfahren für die Herstellung einer organischen lichtemittierenden Vorrichtung umfassend:

das Bereitstellen eines Substrats, das eine gemusterte Anode darauf aufweist;
das Bilden einer Lochtransportlochschicht durch Auftragen einer flüssigen Zusammensetzung umfassend ein Lochtransportmaterial in einem ersten flüssigen Medium;
das Bilden einer photoaktiven Schicht durch Aufbringen einer flüssigen Zusammensetzung umfassend die photoaktive Zusammensetzung nach einem der Ansprüche 1 - 9;
das Bilden einer Elektronentransportschicht; und
das Bilden einer Kathode darüber.

## Revendications

**1.** Composition photoactive comprenant:

(a) 50 à 99% en poids, par rapport au poids total de la composition photoactive, d'au moins une première matière hôte ayant un niveau d'énergie HOMO;
(b) 1 à 10% en poids, par rapport au poids total de la composition photoactive, d'un dopant émissif;
(c) 0,1 à 10% en poids, par rapport au poids total de la composition photoactive, d'un dopant non émissif, lequel dopant non émissif est un complexe organométallique d'iridium ayant un niveau d'énergie HOMO plus bas que le niveau d'énergie HOMO du premier hôte et une bande interdite plus large que celle du dopant émissif; et
(d) 1 à 49% en poids, par rapport au poids total de la composition photoactive, d'une seconde matière hôte ayant un niveau d'énergie HOMO qui est plus profond que le niveau d'énergie HOMO du dopant non émissif, dans laquelle la première matière hôte a la Formule I

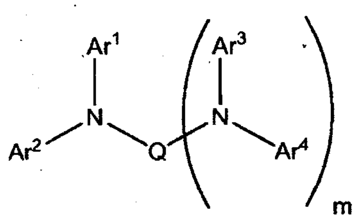

où:

$Ar^1$ à $Ar^4$ sont identiques ou différents et sont aryle;
Q est chrysène, phénanthrène, triphénylène, phénanthroline, naphtalène, anthracène, quinoléine ou isoquinoléine; et
m est un entier de 0 à 6.

**2.** Composition selon la revendication 1, dans laquelle le rapport pondéral de la première matière hôte à la seconde matière hôte est dans la gamme de 19:1 à 2:1.

**3.** Composition selon la revendication 1, dans laquelle au moins une matière est deutérée.

**4.** Composition selon la revendication 1, dans laquelle la première matière hôte a un niveau d'énergie HOMO plus profond que -5,0eV.

**5.** Composition selon la revendication 1, dans laquelle la première matière hôte a une Tg supérieure à 95°C.

**6.** Composition selon la revendication 1, dans laquelle le second hôte est une phénanthroline, une quinoxaline, une phénylpyridine, un benzodifuranne, ou un complexe de quinolate de métal.

**7.** Composition selon la revendication 1, dans laquelle le dopant émissif est un complexe organométallique d'iridium.

**8.** Composition selon la revendication 1, dans laquelle le dopant non émissif a la formule $IrL_3$ ou $IrL_2Y$, où L est un ligand de cyclométallation bidenté monoanionique coordonné par un atome de carbone et un atome d'azote et Y est un ligand bidenté monoanionique.

**9.** Composition selon la revendication 1, dans laquelle le dopant non émissif est l'un de C1 à C14:

C1:

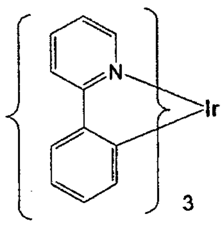

HOMO = -5.17eV

C2:

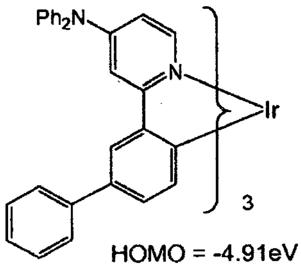

HOMO = -4.91eV

C3:

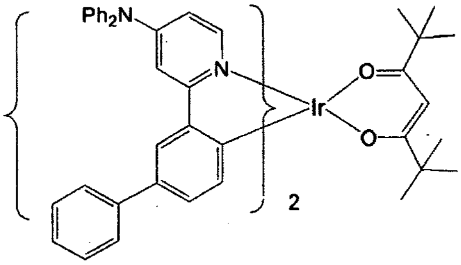

HOMO = -4.84eV

C4:

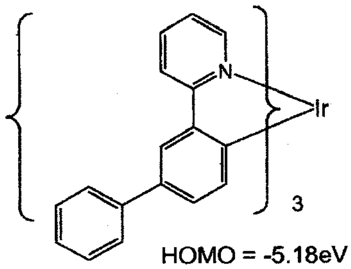

HOMO = -5.18eV

C5:

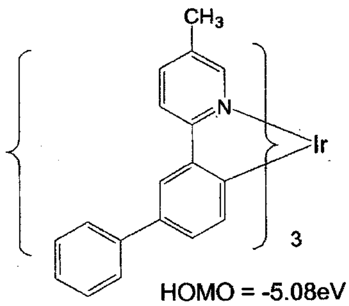

HOMO = -5.08eV

C6:

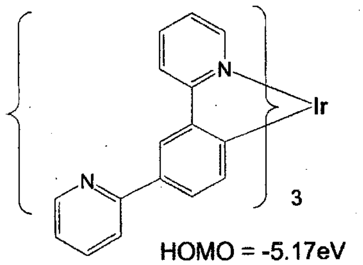

HOMO = -5.17eV

C7:

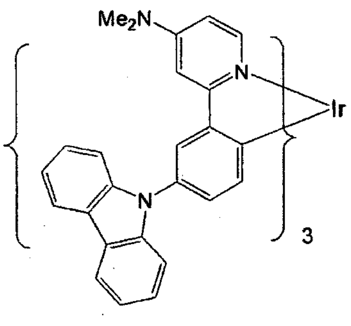

HOMO = -4.94eV

C8:

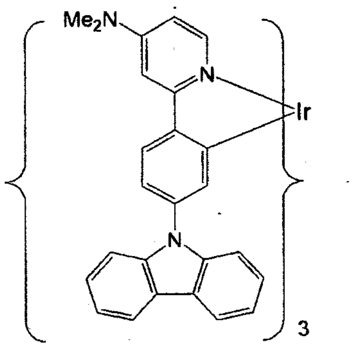

HOMO = -4.91eV

C9:

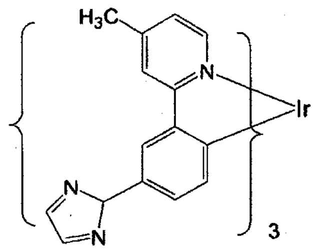

HOMO = -5.03eV

C10:

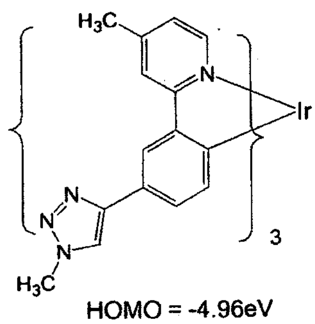

HOMO = -4.96eV

C11:

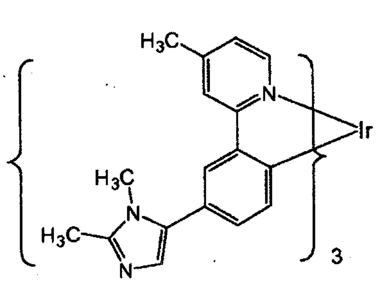

HOMO = -5.06eV

C12:

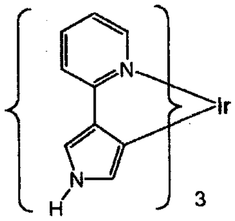

HOMO = -4.48 eV

C13:

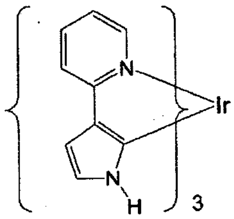

HOMO = -4.77 eV

C14:

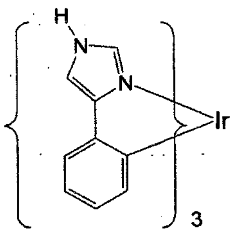

HOMO = -4.68 eV.

**10.** Dispositif électronique comprenant:

une anode;
une couche de transport de trous;
une couche photoactive,
une couche de transport d'électrons, et
une cathode,
dans lequel la couche photoactive comprend:

(a) 50 à 99% en poids, par rapport au poids total de la composition photoactive, d'au moins une première matière hôte ayant un niveau d'énergie HOMO;
(b) 1 à 10% en poids, par rapport au poids total de la composition photoactive, d'un dopant émissif;
(c) 0,1 à 10% en poids, par rapport au poids total de la composition photoactive, d'un dopant non émissif, lequel dopant non émissif est un complexe organométallique d'iridium ayant un niveau d'énergie HOMO plus bas que le niveau d'énergie HOMO du premier hôte et une bande interdite plus large que celle du dopant émissif; et
(d) 1 à 49% en poids, par rapport au poids total de la composition photoactive, d'une seconde matière hôte ayant un niveau d'énergie HOMO qui est plus profond que le niveau d'énergie HOMO du dopant non émissif,

dans laquelle la première matière hôte a la Formule I

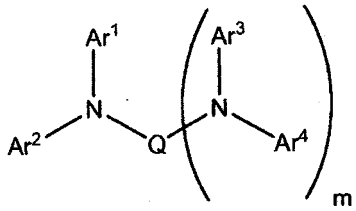

où:

$Ar^1$ à $Ar^4$ sont identiques ou différents et sont aryle;
Q est chrysène, phénanthrène, triphénylène, phénanthroline, naphtalène, anthracène, quinoléine ou isoquinoléine; et
m est un entier de 0 à 6.

**11.** Dispositif selon la revendication 10, dans lequel la composition photoactive comprend une première matière hôte qui est un dérivé de chrysène ayant au moins un substituant diarylamino, une seconde matière hôte qui est un dérivé de phénanthroline, un dopant émissif qui est un complexe organométallique de Ir ayant une émission rouge, et un dopant non émissif qui est un complexe organométallique de Ir ayant un niveau d'énergie HOMO plus bas que le niveau d'énergie HOMO des deux matières hôtes.

**12.** Procédé pour fabriquer un dispositif électroluminescent organique, comprenant:

la fourniture d'un substrat ayant une anode formant un motif sur celui-ci;
la formation d'une couche de transport de trous en déposant une composition liquide comprenant une matière de transport de trous dans un premier milieu liquide;
la formation d'une couche photoactive en déposant une composition liquide comprenant la composition photoactive selon l'une quelconque des revendications 1 à 9;
la formation d'une couche de transport d'électrons; et
la formation d'une cathode au-dessus de l'ensemble.

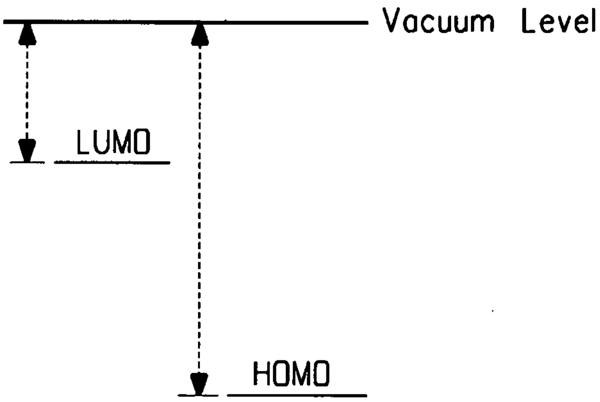
Vacuum Level
LUMO
HOMO

FIG. 1A

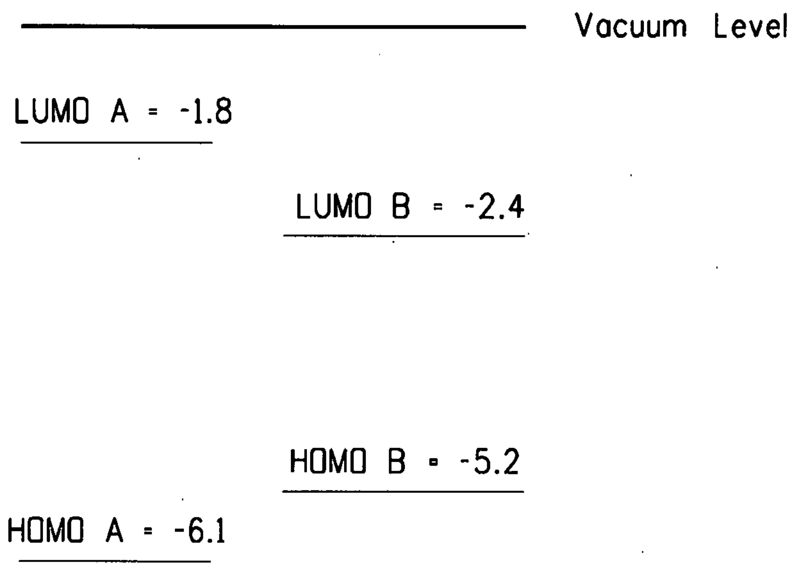
Vacuum Level
LUMO A = -1.8
LUMO B = -2.4
HOMO B = -5.2
HOMO A = -6.1

FIG. 1B

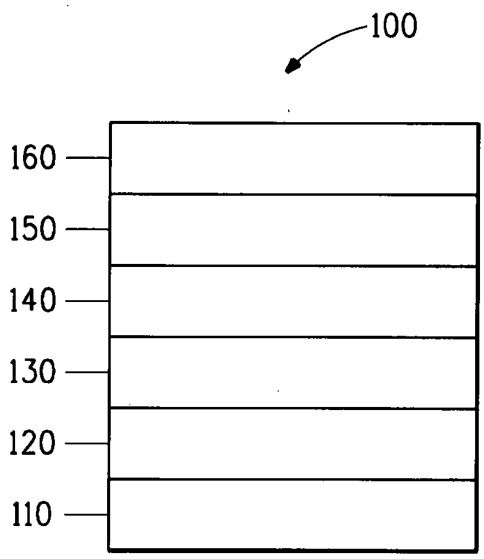
100
160
150
140
130
120
110

FIG. 2

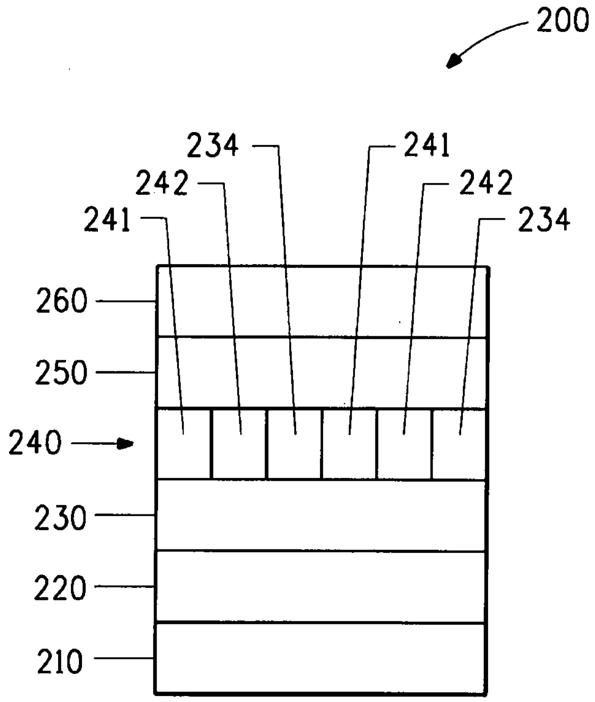
200
234
241
242
242
241
234
260
250
240
230
220
210

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010069442 A
- WO 2010068865 A
- US 6670645 B, Petrov
- WO 03063555 A
- WO 2004016710 A
- WO 03008424 A
- WO 03091688 A
- WO 03040257 A
- US 6875524 B
- US 20070292713 A
- US 20070063638 A
- US 20050158577 A
- WO 2007021117 A
- US 6870054 B
- US 7005522 B
- WO 2003063555 A
- WO 2003008424 A
- WO 2003091688 A
- WO 2003040257 A
- US 20040102577 A
- US 20040127637 A
- US 2005205860 A
- US 20080067473 A
- US 20050205860 A
- WO 2009018009 A
- US 2009067419 A


### Non-patent literature cited in the description


- **OHMORI et al.** *Journal of Display Technology,* June 2007, vol. 3 (2
- CRC Handbook of Chemistry and Physics. 2000
- **MARKUS, JOHN.** Electronics and Nucleonics Dictionary. McGraw-Hill, Inc, 1966, 470, , 476
- Flexible light-emitting diodes made from soluble conducting polymer. *Nature,* 11 June 1992, vol. 357, 477-479
- **Y. WANG.** Kirk-Othmer Encyclopedia of Chemical Technology. 1996, vol. 18, 837-860